# EUROPEAN PATENT APPLICATION

(11) **EP 4 456 115 A1**
(43) Date of publication of application: **30.10.2024**
(21) Application number: 22918813.1
(22) Date of filing: 20.12.2022
(51) Int. Cl.: H01L 21/02

(54) **ADHESIVE AGENT COMPOSITION, LAMINATE, METHOD FOR MANUFACTURING LAMINATE, AND METHOD FOR MANUFACTURING PROCESSED SUBSTRATE**

(30) Priority: 06.01.2022 JP 2022001099
(71) Applicant: Nissan Chemical Corporation, Tokyo 103-6119 (JP)
(72) Inventor: USUI, Yuki, Toyama-shi, Toyama 939-2792 (JP); OKUNO, Takahisa, Toyama-shi, Toyama 939-2792 (JP); YANAI, Masaki, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2022/046833
(87) International publication number: WO 2023/132229

(57) **Abstract**

Provided is an adhesive composition including: a reaction product (X) of a solid polymer (x1) having a first functional group and a liquid chain compound (x2) having, at a chain terminal, a second functional group capable of reacting with the first functional group, the reaction product (X) having the first functional group or the second functional group; and a liquid crosslinking agent (Y) having the first functional group or the second functional group, provided that when the reaction product (X) has the first functional group, the liquid crosslinking agent (Y) has the second functional group, and when the reaction product (X) has the second functional group, the liquid crosslinking agent (Y) has the first functional group.

## Description

### Technical Field

The present invention relates to an adhesive composition, a laminate, a method for producing a laminate, and a method for producing a processed substrate.

### Background Art

Two substrates may be attached using an adhesive composition. At that time, an adhesive coating layer formed from the adhesive composition may protrude from a space between the two substrates. The adhesive coating layer protruding from the space between the two substrates contaminates their surrounding.

In order to prevent a display panel-use adhesive from protruding from an object to be coated or an adherend, it has been proposed to form a liquid stopper (dam) outside the coating region before the display panel-use adhesive is applied (Patent Literatures 1 and 2). However, in order to prevent air from entering the display unit, it is necessary for the display panel-use adhesive to go beyond the liquid stopper. The display panel-use adhesive that has passed over the liquid stopper may protrude from the object to be coated or the adherend, so that the surrounding may be contaminated.

Patent Literature 3 discloses a display panel-use adhesive provided such that the adhesive does not protrude from a member to be bonded using the adhesive, the adhesive including: (A) a polymer containing 1.5 or more polymerizable carbon-carbon double bonds on average in a molecule and having a number average molecular weight (Mn) of 5,000 or more; (B) a polymer containing 1 or less polymerizable carbon-carbon double bonds on average in a molecule and having a number average molecular weight (Mn) of 5,000 or more; (C) a photopolymerization initiator; and (D) a hydrophilic silica having a specific surface area of 200 m²/g or more, wherein the component (D) is in an amount of 4 parts by weight or more and 20 parts by weight or less based on total 100 parts by weight of the components (A) and (B), and wherein a maximum coarse particle size is 30 um or less.

### Citation List

### Patent Literature

Patent Literature 1: JP 2009-8851 A
Patent Literature 2: JP 2010-66711 A
Patent Literature 3: JP 2014-221893 A

### Summary of Invention

### Technical Problem

When two substrates are attached, it may be better to heat the substrates in order to ensure attachment. However, when the two substrates are attached while the substrates are heated, protrusion of the adhesive coating layer formed from the adhesive composition is more likely to occur than when the two substrates are attached at room temperature.

By the way, when two substrates are attached, it is necessary to form a uniform adhesive layer without any void.

The present invention has been made in view of the above circumstances, and addresses the problem of providing: an adhesive composition capable of forming a uniform adhesive layer without any void and suppressing protrusion of an adhesive coating layer from a space between two substrates when the two substrates are attached while being heated; a laminate using the adhesive composition; a method for producing the laminate; and a method for producing a processed substrate using the adhesive composition.

### Solution to Problem

As a result of intensive studies to solve the above problem, the present inventors have found that the above problem can be solved, and have completed the present invention having the following items.

Specifically, the present invention encompasses the following.
[1] An adhesive composition including:
   a reaction product (X) of a solid polymer (x1) having a first functional group and a liquid chain compound (x2) having, at a chain terminal, a second functional group capable of reacting with the first functional group, the reaction product (X) having the first functional group or the second functional group; and
   a liquid crosslinking agent (Y) having the first functional group or the second functional group, provided that when the reaction product (X) has the first functional group, the liquid crosslinking agent (Y) has the second functional group, and when the reaction product (X) has the second functional group, the liquid crosslinking agent (Y) has the first functional group.
[2] The adhesive composition according to [1], wherein
   the solid polymer (x1) is a solid polyorganosiloxane having the first functional group,
   the liquid chain compound (x2) is a compound having the second functional group at a chain terminal and having a siloxane linkage, and
   the liquid crosslinking agent (Y) is a liquid polyorganosiloxane having the first functional group or the second functional group.
[3] The adhesive composition according to [1] or [2], wherein
   the first functional group is a C₂₋₄₀ alkenyl group, and
   the second functional group is a Si-H group.
[4] The adhesive composition according to any one of [1] to [3], wherein
   the solid polymer (x1) is a polyorganosiloxane having a C₂₋₄₀ alkenyl group bonded to a silicon atom,
   the liquid chain compound (x2) is a compound (x21) having a Si-H group at a chain terminal and having a siloxane linkage, and
   the liquid crosslinking agent (Y) is a liquid polyorganosiloxane having a Si-H group.
[5] The adhesive composition according to [4], wherein the compound (x21) is represented by the following formula (x21-1) 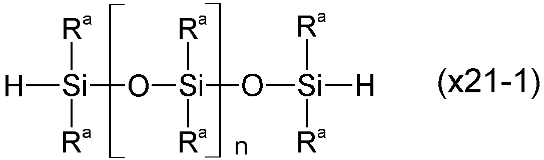 wherein R^{a}s each independently represent a substituted or unsubstituted C₁₋₁₀ hydrocarbon group without any aliphatic unsaturated bond, and n represents an integer of 0 or more.
[6] The adhesive composition according to any one of [1] to [5], wherein a constituent ratio between the solid polymer (x1) and the liquid chain compound (x2) in the reaction product (X) is from 95 : 5 to 10 : 90 as a mass ratio (polymer (x1) : compound (x2)).
[7] The adhesive composition according to any one of [1] to [6], wherein a mass ratio between the reaction product (X) and the liquid crosslinking agent (Y) (reaction product (X) : liquid crosslinking agent (Y)) is from 99 : 1 to 60 : 40.
[8] A laminate including a first substrate, a second substrate, and an adhesive layer provided between the first substrate and the second substrate, wherein
   the adhesive layer is a layer formed from the adhesive composition according to any one of [1] to [7].
[9] The laminate according to [8], further including a release layer provided between the first substrate and the second substrate.
[10] The laminate according to [8] or [9], wherein the first substrate is a substrate including a semiconductor, and the second substrate is a support substrate.
[11] A method for producing a laminate, including steps of:
   applying the adhesive composition according to any one of [1] to [7] to form an adhesive coating layer that provides an adhesive layer; and
   attaching a first substrate and a second substrate under heating and increased pressure so that the first substrate and the second substrate are in contact with each other with the adhesive coating layer interposed therebetween.
[12] The method for producing a laminate as according to [11], further including a step of, after the attaching step, heating the adhesive coating layer to form the adhesive layer.
[13] The method for producing a laminate as according to [11] or [12], further including a step of applying a release agent composition to form a release agent coating layer that provides a release layer, wherein
   the attaching step is a step of attaching under heating and increased pressure so that the first substrate and the second substrate are in contact with each other with the release agent coating layer and the adhesive coating layer interposed therebetween.
[14] The method for producing a laminate as according to any one of [11] to [13], wherein the first substrate is a substrate including a semiconductor, and the second substrate is a support substrate.
[15] A method for producing a processed substrate, including:
   a first step of processing the first substrate of the laminate according to any one of [8] to [10]; and
   a second step of separating the first substrate processed in the first step from the second substrate.

### Advantageous Effects of Invention

The present invention can provide: an adhesive composition capable of forming a uniform adhesive layer without any void and suppressing protrusion of an adhesive coating layer from a space between two substrates when the two substrates are attached while being heated; a laminate using the adhesive composition; a method for producing the laminate; and a method for producing a processed substrate using the adhesive composition.

Note that the void means a state in which air bubbles are present between the substrate and the layer, between the two layers, or in the layer of the laminate. In such a state with unwanted bubbles, when a load such as a pressure necessary for production is applied to the laminate, a bias occurs in the load, and total thickness variation (TTV) deteriorates; non-uniformity of a wafer thickness in the semiconductor substrate processing step (back grinding) occurs; and/or unevenness of pressure applied during the detachment step (during debonding) may cause wafer damage and/or adhesive layer residue. Because of such concerns, reproducible and favorable production of semiconductor elements may not be expected.

### Brief Description of Drawings

Fig. 1 is a schematic cross-sectional view of an example of a laminate.
Fig. 2 is a schematic cross-sectional view of another example of the laminate.
Fig. 3 is a schematic cross-sectional view of another example of the laminate.

### Description of Embodiments

### (Adhesive composition)

The adhesive composition of the present invention contains a reaction product (X) and a crosslinking agent (Y) .

The reaction product (X) is a product obtained by reacting a solid polymer (x1) and a liquid chain compound (x2) .

The solid polymer (x1) has a first functional group.

The liquid chain compound (x2) has a second functional group at a chain terminal.

The reaction product (X) has the first functional group or the second functional group.

The liquid crosslinking agent (Y) has the first functional group or the second functional group.

The second functional group is reactive with the first functional group.

Note that when the reaction product (X) has the first functional group, the liquid crosslinking agent (Y) has the second functional group. When the reaction product (X) has the second functional group, the liquid crosslinking agent (Y) has the first functional group.

As the adhesive composition, an adhesive composition has been known that contains a solid polymer and a liquid crosslinking agent and is used by reacting them after film formation.

The present inventors have conducted intensive research in order to form a uniform adhesive layer without any void and to suppress protrusion of an adhesive coating layer from a space between two substrates when the two substrates are attached, under heating, while using such an adhesive composition.

In order to suppress the protrusion of an adhesive coating layer from a space between the two substrates, it is conceivable to increase the content of the solid polymer, thereby increasing the viscosity of the adhesive composition. However, in that case, the film formability is low, and the formed film is likely to crack.

Therefore, the present inventors have studied to use, instead of the solid polymer, a reaction product obtained by reacting a solid polymer with a liquid chain component.

As a result, by using, instead of the solid polymer, a reaction product obtained by reacting a solid polymer with a liquid chain component, it has been found to be able to form a uniform adhesive layer without any void and to suppress protrusion of an adhesive coating layer from a space between two substrates when the two substrates are attached, under heating. Then, the present invention has been completed.

The present inventors consider, below, the reasons why a uniform adhesive layer without any void can be formed and protrusion of an adhesive coating layer from a space between two substrates can be suppressed when the two substrates are attached, under heating, while using a reaction product obtained by reacting a solid polymer with a liquid chain component.

Specifically, by reacting the solid polymer with the liquid chain component, it has become possible to reduce the ease of cracking of the film and to improve the adhesion by suppressing the protrusion due to viscosity improvement, which is a feature of the solid polymer, and by imparting softness due to the liquid chain component.

In the present invention, the solid state and the liquid state are as follows.

The solid state means a solid state at room temperature (23°C) and normal pressure (1 atm).

The liquid state means a liquid state at room temperature (23°C) and normal pressure (1 atm).

The solid state means a state having substantially no fluidity, and the liquid state means a state having substantial fluidity. For example, in the case of a solid state, viscosity cannot be measured with an E-type viscometer. Note that when the viscosity is 3,000 Pa·s or less, the viscosity can be measured.

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, or a phenol resin-based adhesive.

Among them, a polysiloxane-based adhesive is preferable as the adhesive composition because the adhesive composition exhibits suitable adhesive ability during processing of, for instance, a semiconductor substrate as an example of the first substrate, can be suitably detached after processing, and is excellent in heat resistance.

Examples of the combination of the first functional group and the second functional group include the following combinations. Note that in the following combinations, either may be the first functional group.
Combination (1): combination of a C₂₋₄₀ alkenyl group and a Si-H group;
combination (2): combination of an epoxy group and an amino group;
combination (3): combination of an epoxy group and a carboxy group; and
combination (4): combination of a hydroxyl group and an optionally blocked isocyanate group.

Among them, from the viewpoint of reproducibly realizing the effect of the present invention, the combination (1) is preferable, and the following combination (1-1) is more preferable.

Combination (1-1) : combination of a C₂₋₄₀ alkenyl group as the first functional group and a Si-H group as the second functional group.

The number of first functional groups in the solid polymer (x1) is not particularly limited, but is preferably two or more.

The number of second functional groups in the liquid chain compound (x2) is not particularly limited, but is preferably two or more.

The liquid chain compound (x2) more preferably has one second functional group at each of both ends, and the number of second functional groups in the liquid chain compound (x2) is two.

The number of second functional groups in the liquid crosslinking agent (Y) is not particularly limited, but is preferably two or more.

The solid polymer (x1) is preferably a solid polyorganosiloxane having the first functional group from the viewpoint of reproducibly realizing the effect of the present invention.

As the liquid chain compound (x2), a compound having the second functional group at a chain terminal and having a siloxane linkage is preferable from the viewpoint of reproducibly realizing the effect of the present invention.

As the liquid crosslinking agent (Y), a liquid polyorganosiloxane having the second functional group is preferable, and a liquid chain polyorganosiloxane having the second functional group is more preferable from the viewpoint of reproducibly realizing the effect of the present invention. In the liquid chain polyorganosiloxane, the second functional group may be located at a chain terminal, or may be located at a site other than the chain terminal (e.g., a side chain).

As the solid polymer (x1), a polyorganosiloxane having a C₂₋₄₀ alkenyl group bonded to a silicon atom is more preferable from the viewpoint of reproducibly realizing the effect of the present invention.

As the liquid chain compound (x2), a compound (x21) having a Si-H group at a chain terminal and having a siloxane linkage is more preferable from the viewpoint of reproducibly realizing the effect of the present invention.

The liquid crosslinking agent (Y) is more preferably a liquid polyorganosiloxane having a Si-H group from the viewpoint of reproducibly realizing the effect of the present invention.

As the compound (x21), a compound represented by the following formula (x21-1) is preferable. 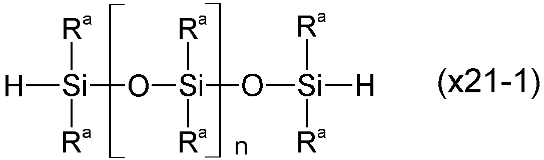 wherein R^{a}s each independently represent a substituted or unsubstituted C₁₋₁₀ hydrocarbon group without any aliphatic unsaturated bond, and n represents an integer of 0 or more.

The n represents, for example, an integer of 0 to 5000.

Preferable examples of R^{a} include a C₁₋₆ alkyl group, a C₅₋₈ cycloalkyl group, a C₆₋₁₀ aryl group, or a C₇₋₁₀ aralkyl group.

More specifically, the alkyl group is, for instance, a methyl group, an ethyl group, a propyl group, or a butyl group; the cycloalkyl group is, for instance, a cyclohexyl group; the aryl group is, for instance, a phenyl group or a tolyl group; and the aralkyl group is, for instance, a benzyl group. Alternatively, examples thereof include a C₁₋₁₀ monovalent hydrocarbon group in which some or all of hydrogen atoms bonded to carbon atoms of these groups are substituted with, for instance, a hydroxy group, a cyano group, a halogen atom, an alkoxysilyl group, a polyoxyalkylene group, an epoxy group, or a carboxyl group.

Among them, a methyl group or a phenyl group is preferable, and a methyl group is particularly preferable.

One kind of the solid polymer (x1) may be used singly or two or more kinds thereof may be used in combination.

One kind of the liquid chain compound (x2) may be used singly or two or more kinds thereof may be used in combination.

One kind of the liquid crosslinking agent (Y) may be used singly or two or more kinds thereof may be used in combination.

The adhesive composition is obtained, for example, by a production method including the following steps (1A) and (2A) .
Step (1A): a step of obtaining a reaction product (X) having a first functional group by reacting a solid polymer (x1) having a first functional group with a liquid chain compound (x2) having, at a chain terminal, a second functional group capable of reacting with the first functional group; and
step (2A): a step of mixing the reaction product (X) having the first functional group with a liquid crosslinking agent (Y) having the second functional group.

In addition, the adhesive composition is obtained, for example, by a production method including the following steps (1B) and (2B).
Step (1B): a step of obtaining a reaction product (X) having a second functional group by reacting a solid polymer (x1) having a first functional group with a liquid chain compound (x2) having, at a chain terminal, a second functional group capable of reacting with the first functional group; and
step (2B): a step of mixing the reaction product (X) having the second functional group with a liquid crosslinking agent (Y) having the first functional group.

In steps (1A) and (1B), the first functional group and the second functional group react with each other to obtain a reaction product (X).

The constituent ratio between the solid polymer (x1) and the liquid chain compound (x2) in the reaction product (X) is not particularly limited, but from the viewpoint of reproducibly realizing the effect of the present invention, the mass ratio (polymer (x1) : compound (x2)) is preferably from 95 : 5 to 10 : 90, more preferably from 90 : 10 to 50 : 50, and particularly preferably from 85 : 15 to 70 : 30.

The mass ratio between the reaction product (X) and the liquid crosslinking agent (Y) (reaction product (X) : liquid crosslinking agent (Y)) in the adhesive composition is not particularly limited, but is preferably from 99 : 1 to 60 : 40, more preferably from 97 : 3 to 70 : 30, and particularly preferably from 95 : 5 to 85 : 15 from the viewpoint of reproducibly realizing the effect of the present invention.

For example, the adhesive composition of the present invention contains a curable component (A) to be an adhesive component.

For example, the curable component (A) contains a reaction product (X) and a liquid crosslinking agent (Y).

The adhesive composition of the present invention may contain a curable component (A) to be an adhesive component and a component (B) that does not cause a curing reaction. Here, examples of the component (B) that does not cause a curing reaction include a polyorganosiloxane. Note that in the present invention, the wording "does not cause a curing reaction" does not mean not causing any curing reaction, but means not causing a curing reaction occurring in the curable component (A).

In another preferred embodiment, the component (A) may be a component that is cured by a hydrosilylation reaction or a polyorganosiloxane component (A') that is cured by a hydrosilylation reaction.

In another preferred embodiment, the component (A) may contain, as an example of the component (A'),
a polyorganosiloxane (a1) having a C₂₋₄₀ alkenyl group bonded to a silicon atom,
a polyorganosiloxane (a2) having a Si-H group, and
a platinum group metal-based catalyst (A2).

Here, the polyorganosiloxane (a1) corresponds to the reaction product (X).

The polyorganosiloxane (a2) corresponds to the liquid crosslinking agent (Y).

The C₂₋₄₀ alkenyl group may be substituted. Examples of the substituent include a halogen atom, a nitro group, a cyano group, an amino group, a hydroxy group, a carboxyl group, an aryl group, or a heteroaryl group.

In another preferred embodiment, the polyorganosiloxane component (A') cured by the hydrosilylation reaction contains a platinum group metal-based catalyst (A2) and a polysiloxane (A1) containing one or two or more units selected from the group consisting of siloxane units (Q units) represented by SiO₃, siloxane units (M units) represented by R¹R²R³SiO_{1/2}, siloxane units (D units) represented by R⁴R⁵SiO_{2/2}, and siloxane units (T units) represented by R⁶SiO_{3/2},.

The polysiloxane (A1) contains a polyorganosiloxane (a1') which is an example of the reaction product (X) and a polyorganosiloxane (a2') which is an example of the liquid crosslinking agent (Y).

The polyorganosiloxane (a1') is, for example, a reaction product of a polyorganosiloxane (a1'-1) and a compound represented by the formula (x21-1).

The polyorganosiloxane (a1'-1) contains one or two or more units selected from the group consisting of siloxane units (Q' units) represented by SiO₃, siloxane units (M' units) represented by R¹'R²'R³'SiO_{1/2}, siloxane units (D' units) represented by R⁴'R⁵'SiO_{2/2}, and siloxane units (T' units) represented by R⁶'SiO_{3/2}, and also contains at least one selected from the group consisting of M' units, D' units, and T' units.

The polyorganosiloxane (a2') contains one or two or more units selected from the group consisting of siloxane units (Q" units) represented by SiO₂, siloxane units (M'' units) represented by R¹"R²"R³"SiO_{1/2}, siloxane units (D" units) represented by R⁴"R⁵"SiO_{2/2}, and siloxane units (T" units) represented by R⁶"SiO_{3/2}, and also contains at least one selected from the group consisting of M" units, D" units, and T" units.

Note that (a1') is an example of (a1), and (a2') is an example of (a2).

R¹ to R⁶ are each a group or an atom bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, or a heteroaryl group.

R¹'to R⁶' are each a group bonded to a silicon atom, and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, or a heteroaryl group.

R¹"to R⁶" are each a group or atom bonded to a silicon atom and each independently represent an optionally substituted alkyl group or a hydrogen atom, and at least one of R¹"to R⁶" is a hydrogen atom. Examples of the substituent include a halogen atom, a nitro group, a cyano group, an amino group, a hydroxy group, a carboxyl group, an aryl group, or a heteroaryl group.

The alkyl group may be linear, branched, or cyclic, and is preferably a linear or branched alkyl group. The number of carbon atoms is not particularly limited, but is usually from 1 to 40, preferably 30 or less, more preferably 20 or less, and still more preferably 10 or less.

Specific examples of the optionally substituted linear or branched alkyl group include, but are not limited to, a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, or a 1-ethyl-2-methyl-n-propyl group. The number of carbon atoms is usually from 1 to 14, preferably from 1 to 10, and more preferably from 1 to 6. Among them, a methyl group is particularly preferable.

Specific examples of the optionally substituted cyclic alkyl group include, but are not limited to, a cycloalkyl group (e.g., a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group) or a bicycloalkyl group (e.g., a bicyclobutyl group, a bicyclopentyl group, a bicyclohexyl group, a bicycloheptyl group, a bicyclooctyl group, a bicyclononyl group, a bicyclodecyl group). The number of carbon atoms is usually from 3 to 14, preferably from 4 to 10, and more preferably from 5 to 6.

the alkenyl group may be either linear or branched. The number of carbon atoms is not particularly limited, but is usually from 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, or a pentenyl group. The number of carbon atoms is usually from 2 to 14, preferably from 2 to 10, and more preferably from 1 to 6. Among them, an ethenyl group or a 2-propenyl group is particularly preferable.

Specific examples of the optionally substituted cyclic alkenyl group include, but are not limited to, cyclopentenyl or cyclohexenyl. The number of carbon atoms is usually from 4 to 14, preferably from 5 to 10, and more preferably from 5 to 6.

As described above, the polysiloxane (A1) includes a polyorganosiloxane (a1') and a polyorganosiloxane (a2'). An alkenyl group contained in the polyorganosiloxane (a1') and a hydrogen atom (Si-H group) contained in the polyorganosiloxane (a2') form a crosslinked structure by a hydrosilylation reaction using a platinum group metal-based catalyst (A2) and are cured. As a result, a cured film is formed.

The polyorganosiloxane (a1'-1) contains one or two or more units selected from the group consisting of Q' units, M' units, D' units, and T' units, and contains at least one selected from the group consisting of M' units, D' units, and T' units. As the polyorganosiloxane (a1'-1), two or more kinds of polyorganosiloxane satisfying such conditions may be used in combination.

Examples of the referred combination of two or more units selected from the group consisting of Q' units, M' units, D' units, and T' units include, but are not limited to, (Q' units and M' units), (D' units and M' units), (T' units and M' units), or (Q' units, T' units, and M' units).

In addition, when the polyorganosiloxane (a1'-1) contains two or more kinds of polyorganosiloxane, a combination of (Q' units and M' units) and (D' units and M' units), a combination of (T' units and M' units) and (D' units and M' units), or a combination of (Q' units, T' units, and M' units) and (T' units and M' units) is preferable, but the combination is not limited thereto.

The polyorganosiloxane (a2') contains one or two or more units selected from the group consisting of Q" units, M" units, D" units, and T" units, and contains at least one selected from the group consisting of M" units, D" units, and T" units. As the polyorganosiloxane (a2'), two or more kinds of polyorganosiloxane satisfying such conditions may be used in combination.

Examples of the preferred combination of two or more units selected from the group consisting of Q" unit, M" units, D" units, and T" units include, but are not limited to, (M" units and D" units), (Q" units and M" units), or (Q" units, T" units, and M" units).

The polyorganosiloxane (a1'-1) is composed of a siloxane unit in which an alkyl group and/or an alkenyl group is bonded to a silicon atom thereof. Here, the proportion of alkenyl groups in all the substituents represented by R¹' to R⁶' is preferably from 0.1 to 50.0 mol% and more preferably from 0.5 to 30.0 mol% while the remaining R¹' to R⁶' may each be an alkyl group.

The polyorganosiloxane (a2') is composed of a siloxane unit in which an alkyl group and/or a hydrogen atom is bonded to a silicon atom thereof. Here, the proportion of hydrogen atoms in all the substituted atoms and substituents represented by R¹" to R⁶" is preferably from 0.1 to 50.0 mol% and more preferably from 10.0 to 40.0 mol% while the remaining R¹" to R⁶" may each be an alkyl group.

When the component (A) contains (a1) and (a2), in a preferred embodiment of the present invention, the molar ratio between the alkenyl groups contained in the polyorganosiloxane (a1) and the hydrogen atoms constituting the Si-H bonds contained in the polyorganosiloxane (a2) is in the range of 1.0 : 0.5 to 1.0 : 0.66.

The weight average molecular weight of polysiloxane such as the polyorganosiloxane (a1) or the polyorganosiloxane (a2) is not particularly limited, but is usually from 100 to 1,000,000 and is preferably from 5,000 to 800,000 from the viewpoint of reproducibly realizing the effect of the present invention.

Note that in the present invention, the weight average molecular weight, the number average molecular weight, and the dispersibility of the polyorganosiloxane can be measured, for example, using a GPC apparatus (HLC-8320GPC,manufactured by Tosoh Corporation) and a GPC column (TSKgel SuperMultiporeHZ-N and TSKgel SuperMultiporeHZ-H, manufactured by Tosoh Corporation) at a column temperature of 40°C while using tetrahydrofuran as an eluent (eluent solvent) at a flow rate (flow velocity) of 0.35 mL/min and using polystyrene (Shodex manufactured by Showa Denko K.K.) as a standard sample.

The viscosities of the polyorganosiloxane (a1) and the polyorganosiloxane (a2) are not particularly limited, but are each usually in the range of 10 to 1000000 (mPa·s). The viscosities (mPa·s) of the polyorganosiloxane (a1) and the polyorganosiloxane (a2) are each a value measured with an E-type rotational viscometer at 25°C.

Provided that the viscosities of the polyorganosiloxane (a1) and the polyorganosiloxane (a2) are not necessarily required to fall within the above-mentioned range. Some polyorganosiloxanes having a complex viscosity value in the predetermined range in the present invention have a viscosity outside the range, and some polyorganosiloxanes have a viscosity that cannot be measured with an E-type rotational viscometer.

The polyorganosiloxane (a1) and the polyorganosiloxane (a2) react with each other by a hydrosilylation reaction to form a film. The mechanism of its curing is therefore different from that via a silanol group, for example. Therefore, any siloxane does not need to contain a silanol group or a functional group (e.g., an alkyloxy group) that forms a silanol group by hydrolysis.

In a preferred embodiment of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, a platinum-based catalyst (e.g., platinum black, platinic chloride, chloroplatinic acid, a reaction product of chloroplatinic acid and monohydric alcohol, a complex of chloroplatinic acid and olefin, platinum bisacetoacetate).

Examples of the complex of platinum and olefin include, but are not limited to, a complex of divinyltetramethyldisiloxane and platinum.

The amount of platinum group metal-based catalyst (A2) is not particularly limited, but is usually in the range of 1.0 to 50.0 ppm based on the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include an alkynyl alcohol (e.g., 1-ethynyl-1-cyclohexanol, 1,1-diphenyl-2-propion-1-ol).

The amount of the polymerization inhibitor is not particularly limited, but is usually 1000.0ppm or more based on the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition of the present invention may contain, in addition to the component (A), a component (B) that does not cause a curing reaction. By including such a component (B) in the adhesive composition, an adhesive composition satisfying the first condition or the second condition is easily obtained.

Typical examples of the component (B) include a non-curable polyorganosiloxane, and specific examples thereof include, but are not limited to, an epoxy group-containing polyorganosiloxane, a methyl group-containing polyorganosiloxane, or a phenyl group-containing polyorganosiloxane.

Also, examples of the component (B) include a non-curable polydimethylsiloxane. The polydimethylsiloxane may be modified. Examples of the optionally modified polydimethylsiloxane include, but are not limited to, an epoxy group-containing polydimethylsiloxane, an unmodified polydimethylsiloxane, or a phenyl group-containing polydimethylsiloxane.

Preferred examples of the non-curable polyorganosiloxane as the component (B) include, but are not limited to, an epoxy group-containing polyorganosiloxane, a methyl group-containing polyorganosiloxane, or a phenyl group-containing polyorganosiloxane.

The weight average molecular weight of the non-curable polyorganosiloxane as the component (B) is not particularly limited, but is usually from 100,000 to 2,000,000, and is preferably from 150,000 to 1,200,000 and more preferably from 200,000 to 800,000 from the viewpoint of reproducibly realizing the effect of the present invention. The dispersibility is not particularly limited, but is usually from 1.0 to 10.0, preferably from 1.5 to 5.0, and more preferably from 2.0 to 3.0.

The viscosity of the non-curable polyorganosiloxane is not particularly limited, but is usually in the range of 10 to 1000000 (mPa·s). The viscosity (mPa·s) of the non-curable polyorganosiloxane is a value measured with an E-type rotational viscometer at 25°C.

Provided that the viscosity of the non-curable polyorganosiloxane is not necessarily required to fall within the above-mentioned range. Some polyorganosiloxanes having a complex viscosity value in the predetermined range in the present invention have a viscosity outside the range, and some polyorganosiloxanes have a viscosity that cannot be measured with an E-type rotational viscometer.

Examples of the epoxy group-containing polyorganosiloxane include those containing a siloxane unit (D¹⁰ unit) represented by R¹¹R¹²SiO_{2/2}.

R¹¹ is a group bonded to a silicon atom, and represents an alkyl group; R¹² is a group bonded to a silicon atom, and represents an epoxy group or an epoxy group-containing organic group; and specific examples of the alkyl group can include the above examples.

The epoxy group in the epoxy group-containing organic group may be an independent epoxy group without being fused to another ring, or may be an epoxy group forming a fused ring with another ring, such as a 1,2-epoxycyclohexyl group.

Specific examples of the epoxy group-containing organic group include, but are not limited to, 3-glycidoxypropyl or 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the above-described siloxane unit (D¹⁰ unit), but may contain, in addition to the D¹⁰ unit, a Q unit, an M unit, and/or a T unit.

In a preferred embodiment of the present invention, specific examples of the epoxy group-containing polyorganosiloxane include a polyorganosiloxane consisting of D¹⁰ units, a polyorganosiloxane containing D¹⁰ units and Q units, a polyorganosiloxane containing D¹⁰ units and M units, a polyorganosiloxane containing D¹⁰ units and T units, a polyorganosiloxane containing D¹⁰ units, Q units, and M units, a polyorganosiloxane containing D¹⁰ units, M units, and T units, or a polyorganosiloxane containing D¹⁰ units, Q units, M units, and T units.

The epoxy group-containing polyorganosiloxane is preferably an epoxy group-containing polydimethylsiloxane having an epoxy value of 0.1 to 5. In addition, the weight average molecular weight thereof is not particularly limited, but is usually from 1,500 to 500,000, and is preferably 100,000 or less from the viewpoint of suppressing precipitation in the composition.

Specific examples of the epoxy group-containing polyorganosiloxane include, but are not limited to, those represented by formulas (E1) to (E3). 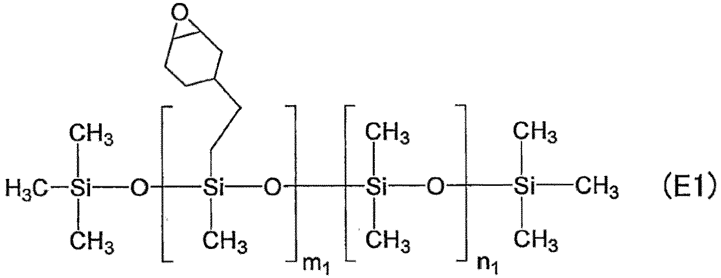 wherein m₁ and n₁ each represent the number of respective repeating units, and are positive integers. 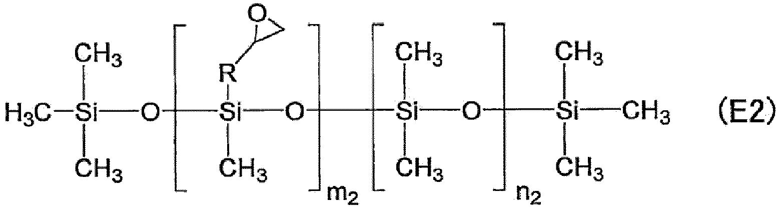 wherein m₂ and n₂ each represent the number of respective repeating units and are positive integers, and R is a C₁₋₁₀ alkylene group. 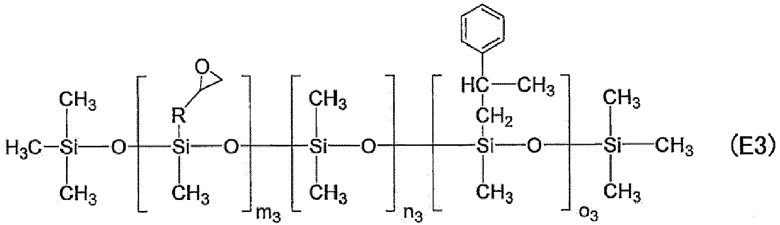 wherein m₃, n₃, and o₃ each represent the number of respective repeating units and are positive integers, and R is a C₁₋₁₀ alkylene group.

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are each a group bonded to a silicon atom, and each independently represent an alkyl group, but at least one thereof is a methyl group, and specific examples of the alkyl group can include the above-described examples.

R²¹ is a group bonded to a silicon atom and represents an alkyl group, and specific examples of the alkyl group can include the above-described examples. Among them, a methyl group is preferable as R²¹.

In the present invention, preferred examples of the methyl group-containing polyorganosiloxane include, but are not limited to, a polydimethylsiloxane.

The methyl group-containing polyorganosiloxane contains the above-described siloxane units (D²⁰⁰ units or D²⁰ units), but may contain Q units, M units, and/or T units in addition to D²⁰⁰ units and D²⁰ units.

In an embodiment of the present invention, specific examples of the methyl group-containing polyorganosiloxane include a polyorganosiloxane consisting of D²⁰⁰ units, a polyorganosiloxane containing D²⁰⁰ units and Q units, a polyorganosiloxane containing D²⁰⁰ units and M units, a polyorganosiloxane containing D²⁰⁰ units and T units, a polyorganosiloxane containing D²⁰⁰ units, Q units, and M units, a polyorganosiloxane containing D²⁰⁰ units, M units, and T units, or a polyorganosiloxane containing D²⁰⁰ units, Q units, M units, and T units.

In a preferred embodiment of the present invention, specific examples of the methyl group-containing polyorganosiloxane include a polyorganosiloxane consisting of D²⁰ units, a polyorganosiloxane containing D²⁰ units and Q units, a polyorganosiloxane containing D²⁰ units and M units, a polyorganosiloxane containing D²⁰ units, T units, a polyorganosiloxane containing D²⁰ units, Q units, and M units, a polyorganosiloxane containing D²⁰ units, M units, and T units, or a polyorganosiloxane containing D²⁰ units, Q units, M units, and T units.

Specific examples of the methyl group-containing polyorganosiloxane include, but are not limited to, those represented by formula (M1). 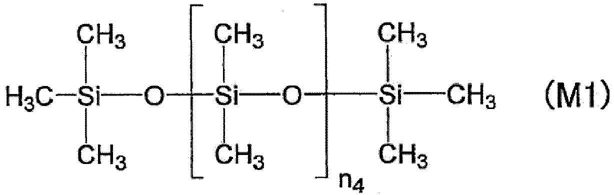 wherein n₄ represents the number of repeating units, and is a positive integer.

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group; R³² is a group bonded to a silicon atom and represents a phenyl group; and specific examples of the alkyl group include the above-described examples, but a methyl group is preferable.

The phenyl group-containing polyorganosiloxane contains the above-described siloxane unit (D³⁰ unit), but may contain a Q unit, an M unit, and/or a T unit in addition to the D³⁰ unit.

In a preferred embodiment of the present invention, specific examples of the phenyl group-containing polyorganosiloxane include a polyorganosiloxane consisting of D³⁰ units, a polyorganosiloxane containing D³⁰ units and Q units, a polyorganosiloxane containing D³⁰ units and M units, a polyorganosiloxane containing D³⁰ units, T units, a polyorganosiloxane containing D³⁰ units, Q units, and M units, a polyorganosiloxane containing D³⁰ units, M units, and T units, or a polyorganosiloxane containing D³⁰ units, Q units, M units, and T units.

Specific examples of the phenyl group-containing polyorganosiloxane include, but are not limited to, those represented by formula (P1) or (P2). 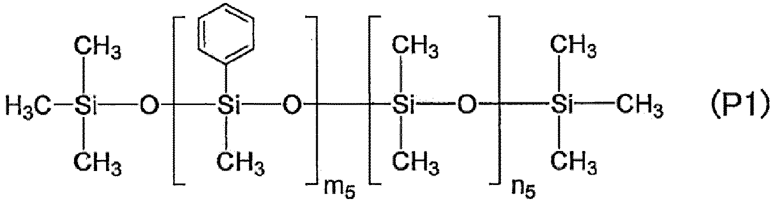 wherein m₅ and n₅ each represent the number of respective repeating units, and are positive integers. 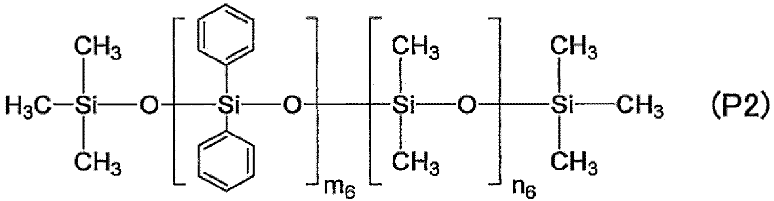 wherein m₆ and n₆ each represent the number of respective repeating units, and are positive integers.

In one embodiment, the adhesive composition of the present invention contains, in addition to the component (A), a component (B) that does not cause a curing reaction, and in a more preferred embodiment, a polyorganosiloxane is contained as the component (B).

An example of the adhesive composition of the present invention can contain the component (A) and the component (B) in any ratio, but in consideration of ease of adjusting the complex viscosity of the adhesive coating layer to a desired range, the ratio between the component (A) and the component (B) is preferably from 90 : 10 to 10 : 90, and more preferably from 80 : 20 to 20 : 80 in mass ratio [(A) . (B)].

That is, when the polyorganosiloxane component (A') cured by a hydrosilylation reaction is contained, the ratio between the component (A') and the component (B) is preferably from 90 : 10 to 10 : 90, and more preferably from 80 : 20 to 20 : 80 in mass ratio [(A') : (B)].

The adhesive composition of the present invention may contain a solvent for the purpose of, for instance, adjusting the viscosity, and specific examples thereof include, but are not limited to, aliphatic hydrocarbon, aromatic hydrocarbon, or ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, or 5-nonanone. One kind of such a solvent may be used singly, or two or more kinds thereof may be used in combination.

When the adhesive composition of the present invention contains a solvent, the content thereof is determined, if appropriate, in consideration of, for instance, the viscosity of the desired composition, the coating method to be employed, and the thickness of the film to be produced, but is in the range of about 10 to 90 mass% based on the entire composition.

An example of the adhesive composition of the present invention may be produced by mixing the component (A) with the component (B) and a solvent when used.

The mixing order is not particularly limited, but examples of the method for easily and reproducibly producing the adhesive composition include, but are not limited to, a method in which the component (A) and the component (B) are dissolved in a solvent, or a method in which parts of the component (A) and the component (B) are dissolved in a solvent, the rest are dissolved in a solvent, and the resulting solutions are mixed. Note that when the adhesive composition is prepared, the components may be heated, if appropriate, as long as the components are not decomposed or modified.

In the present invention, in order to remove foreign substances, for example, a solvent and/or a solution to be used may be filtered using, for instance, a filter during the production of the adhesive composition or after mixing of all the components.

The adhesive composition may be used for permanent adhesion of two substrates or for temporary adhesion of two substrates.

The permanent adhesion is adhesion provided such that an adhesive layer formed from the adhesive composition is present in the final product while being interposed between the two substrates. The permanent adhesion is, for example, adhesion between an object to be coated and an adherend in manufacturing of a display panel as described in JP-A-2014-221892.

The temporary adhesion of substrates is temporary adhesion of two substrates for processing of one of the two substrates. Therefore, the two substrates temporarily attached by using the adhesive composition are detached from each other after one of the substrates is processed. Examples of the temporary adhesion include temporary adhesion of a support substrate to a substrate, the back surface of which is subject to processing (e.g., processing such as grinding processing, TSV processing, or electrode formation) as described in JP-A-2021-14507. In addition, the temporary adhesion may be, for example, temporary adhesion to a support substrate for processing a warped substrate (e.g., a wafer) as described in Japanese Patent No. 6167984.

### (Laminate)

The laminate of the present invention includes a first substrate, a second substrate, and an adhesive layer, and further optionally includes other layers such as a release layer and/or an inorganic material layer.

### <First substrate>

The first substrate is not particularly limited as long as it is a substrate constituting the laminate together with the second substrate.

In addition, the material, shape, size, and structure of the first substrate are not particularly limited.

The first substrate may be made of an organic material, an inorganic material, or both an organic material and an inorganic material.

The first substrate is, for example, a substrate (hereinafter, sometimes referred to as a "semiconductor substrate") including a semiconductor.

The semiconductor substrate is a substrate including a semiconductor material (e.g., silicon, silicon carbide, compound semiconductor) in a process of manufacturing a semiconductor product (e.g., an integrated circuit (IC), a large scale integration (LSI)). Examples thereof include a semiconductor wafer on which a circuit is formed, or a substrate produced by molding, with a resin, a chip obtained by dicing the wafer.

An example of the semiconductor substrate will be described below.

The main material constituting the entire semiconductor substrate is not particularly limited, and examples thereof include silicon, silicon carbide, or a compound semiconductor.

The shape of the semiconductor substrate is not particularly limited, and is, for example, a disk shape. Note that the disk-shaped semiconductor substrate does not need to have a completely circular surface shape, and for example, the outer periphery of the semiconductor substrate may have a straight portion called an orientation flat or may have a cut called a notch.

The thickness of the disk-shaped semiconductor substrate may be appropriately determined according to, for instance, the purpose of use of the semiconductor substrate, and is not particularly limited, but is, for example, from 500 to 1,000 um.

The diameter of the disk-shaped semiconductor substrate may be appropriately determined according to, for instance, the purpose of use of the semiconductor substrate, and is not particularly limited, but is, for example, from 100 to 1,000 mm.

The semiconductor substrate may have a bump. The bump is a protruding terminal.

In the laminate, when the semiconductor substrate has a bump, the semiconductor substrate has a bump on the support substrate side.

In the semiconductor substrate, a bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, diameter, and pitch of the bump are appropriately determined from the conditions of a bump height of about 1 to 200 um, a bump diameter of 1 to 200 um, and a bump pitch of 1 to 500 um.

Examples of the material of the bump include low-melting-point solder, high-melting-point solder, tin, indium, gold, silver, or copper. The bump may be composed of only a single component or may be composed of a plurality of components. More specific examples thereof include alloy plating mainly containing Sn, such as a SnAg bump, a SnBi bump, a Sn bump, or an AuSn bump.

In addition, the bump may have a laminated structure including a metal layer made of at least one of these components.

An example of the semiconductor substrate is a silicon wafer having a diameter of about 300 mm and a thickness of about 770 um.

### <Second substrate>

The second substrate is not particularly limited as long as it is a substrate constituting the laminate together with the first substrate.

In addition, the material, shape, size, and structure of the second substrate are not particularly limited.

The second substrate may be made of an organic material, an inorganic material, or both an organic material and an inorganic material.

The second substrate is, for example, a support substrate that supports the first substrate when the first substrate is processed.

The support substrate is not particularly limited as long as it is a member capable of supporting the first substrate when the first substrate is processed, and examples thereof include a glass support substrate or a silicon support substrate.

The shape of the support substrate is not particularly limited, and examples thereof include a disk shape. Note that the disk-shaped support substrate does not need to have a completely circular surface shape, and for example, the outer periphery of the support substrate may have a straight portion called an orientation flat or may have a cut called a notch.

The thickness of the disk-shaped support substrate may be appropriately determined according to, for instance, the size of the semiconductor substrate, and is not particularly limited, but is, for example, from 500 to 1,000 um.

The diameter of the disk-shaped support substrate may be appropriately determined according to, for instance, the size of the semiconductor substrate, and is not particularly limited, but is, for example, from 100 to 1,000 mm.

An example of the support substrate is a glass wafer or a silicon wafer having a diameter of about 300 mm and a thickness of about 700 µm.

### <Adhesive layer>

The adhesive layer is provided between the first substrate and the second substrate.

The adhesive layer is a layer formed from the adhesive composition of the present invention.

The method of forming an adhesive layer from the adhesive composition of the present invention will be illustrated in detail in the description of (Method for producing laminate) described below.

The thickness of the adhesive layer is not particularly limited, but is usually from 5 to 500 µm, and is preferably 10 um or larger, more preferably 20 um or larger, and still more preferably 30 um or larger from the viewpoint of maintaining the film strength, and is preferably 200 um or less, more preferably 150 um or less, still more preferably 120 um or less, and still more preferably 70 um or less from the viewpoint of avoiding nonuniformity caused by a thick film.

### <Release layer>

The laminate of the present invention may include a release layer.

When the laminate has a release layer, the release layer is provided between the first substrate and the second substrate.

When the laminate has a release layer, for example, the release layer can be disposed so as to be in contact with the second substrate and the adhesive layer.

The release layer is not particularly limited as long as the release layer can be peeled off by heating, light irradiation, or mechanical force to contribute to separation between the first substrate and the second substrate in the laminate. For example, a release layer described below can be used.

In a preferred embodiment, the release layer is a film obtained from a release agent composition containing an organic resin and a solvent, and in one embodiment, the film is a cured film obtained by curing a film constituent component in the release agent composition.

The release agent composition may further contain a crosslinking agent, an acid catalyst, and a surfactant.

### <<Organic resin>>

The release agent composition contains an organic resin. Such an organic resin is preferably one that can exhibit suitable release capability. When the first substrate and the second substrate are separated by irradiating the release layer with light, the organic resin absorbs light to suitably cause modification, for example, decomposition, necessary for improving the release capability.

Preferable examples of the organic resin include a novolac resin.

When the release layer included in the laminate of the present invention is detached by irradiation with light, a novolak resin that absorbs light with a wavelength of 190 nm to 600 nm and is modified is preferable, and a novolak resin that is modified by irradiation with light (e.g., laser beam) at a wavelength of 308 nm, 343 nm, 355 nm, or 365 nm is more preferable.

As a specific example, the novolac resin is a polymer containing one or two or more kinds selected from the group consisting of units represented by the following formula (C1-1), units represented by the following formula (C1-2), and units represented by the following formula (C1-3).

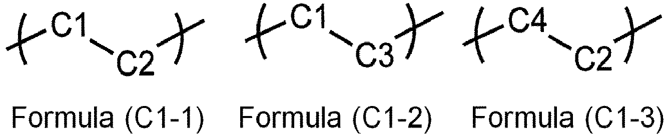

C1 represents a group derived from an aromatic compound containing a nitrogen atom, C2 represents a group containing a tertiary carbon atom having, at a side chain, at least one selected from the group consisting of secondary carbon atoms, quaternary carbon atoms, and aromatic rings, C3 represents a group derived from an aliphatic polycyclic compound, and C4 represents a group derived from phenol, a group derived from bisphenol, a group derived from naphthol, a group derived from biphenyl, or a group derived from biphenol.

For the novolac resin to be contained in the release agent composition and the release layer using the novolac resin, the novolac resin and the release layer using the novolac resin as described in WO 2019/088103 A can be taken into consideration.

Preferable examples of the organic resin include a combination of a novolac resin and a (meth)acrylic acid ester-based polymer.

The (meth)acrylic acid ester-based polymer is a polymer containing a repeating unit derived from a (meth)acrylic acid alkyl ester.

The (meth)acrylic acid alkyl ester is a generic term for acrylic acid alkyl esters and methacrylic acid alkyl esters.

The number of carbon atoms in the (meth)acrylic acid alkyl ester is not particularly limited, but is preferably from 4 to 20 and more preferably from 4 to 10.

Examples of the acrylic acid alkyl ester include methyl acrylate, ethyl acrylate, n-propyl acrylate, n-butyl acrylate, isobutyl acrylate, n-pentyl acrylate, n-hexyl acrylate, n-octyl acrylate, isooctyl acrylate, 2-ethylhexyl acrylate, dodecyl acrylate, or decyl acrylate.

Examples of the methacrylic acid alkyl ester include methyl methacrylate, ethyl methacrylate, n-propyl methacrylate, n-butyl methacrylate, isobutyl methacrylate, n-pentyl methacrylate, n-hexyl methacrylate, n-octyl methacrylate, isooctyl methacrylate, 2-ethylhexyl methacrylate, dodecyl methacrylate, or decyl methacrylate. One kind of them may be used singly or two or more kinds thereof may be used in combination.

Among them, methyl methacrylate (methacrylic acid methyl ester) is preferable.

The (meth)acrylic acid ester-based polymer may have a repeating unit other than the repeating unit derived from the (meth)acrylic acid alkyl ester. Examples of the monomer constituting such a repeating unit include a polymerizable unsaturated group-containing monomer other than the (meth)acrylic acid ester-based polymer. Examples of such a monomer include a carboxyl group-containing monomer, a hydroxy group-containing monomer, a (meth)acrylamide-based monomer, or a styrene-based monomer.

The (meth)acrylic acid ester-based polymer may be a homopolymer or a copolymer.

The (meth)acrylic acid ester-based polymer preferably contains polymethyl methacrylate (polymethyl methacrylic acid ester).

The molar ratio of the repeating unit derived from the (meth)acrylic acid alkyl ester in all the repeating units of the (meth)acrylic acid ester-based polymer is not particularly limited, but is preferably from 50 mol% to 100 mol%, more preferably from 75 mol% to 100 mol%, and particularly preferably from 90 mol% to 100 mol%.

Preferable examples of the organic resin include polyimide or a polyimide precursor. Examples of the polyimide precursor include a polyamic acid (polyamic acid).

The polyamic acid contains, for example, one or more units selected from structural units represented by the following formulas (5) and (6). 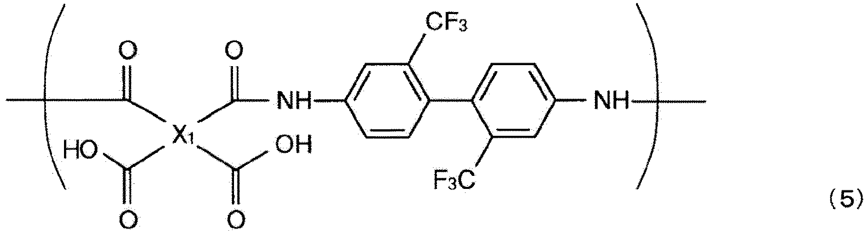 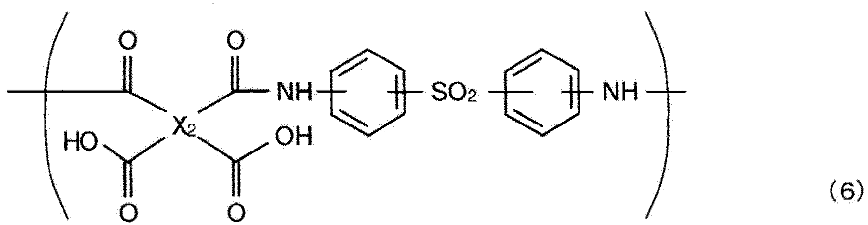 wherein X₁ and X₂ are each independently a C₄₋₃₂ tetravalent organic group.

In addition, examples of the polyamic precursor include a polyimide precursor having an absorbance at 308 nm of 0.1 or more and 0.8 or less when heated at 350°C for 1 hour to form a polyimide resin film with a film thickness of 0.1 um. Examples of such a polyimide precursor include the polyimide precursor described in Japanese Patent No. 6732871.

In another preferred embodiment, the release layer is a film obtained from a release agent composition containing a polyorganosiloxane and, if necessary, a solvent.

The polyorganosiloxane may be a commercially available product or a synthetic product.

Examples of the polyorganosiloxane commercially available product include trade name AK 50 manufactured by Wacker Chemie AG.

The thickness of the release layer included in the laminate according to the present invention is appropriately determined in consideration of, for instance, the type of the release agent component and/or the desired degree of releasability, but is usually from 5 to 10,000 nm. From the viewpoints of suppressing deterioration of release capability due to a thin film and reproducibly obtaining a release layer excellent in releasability, the thickness is preferably 10 nm or larger, more preferably 50 nm or larger, and still more preferably 100 nm or larger. From the viewpoint of avoiding non-uniformity due to a thick film, the thickness is preferably 5,000 nm or less, more preferably 1,000 nm or less, and still more preferably 500 nm or less.

### <<Crosslinking agent>>

The release agent composition may include a crosslinking agent. Inclusion of the crosslinking agent in the release agent composition suitably promotes, depending on the type of resin together included, the crosslinking between resins, thereby capable of realizing suitable curing. As a result, a film can be reproducibly obtained that cannot be suitably removed by an organic solvent, an acid, and a chemical liquid (e.g., an alkali developer, hydrogen peroxide water) used in the production of a semiconductor element but can be suitably removed by a cleaning agent composition.

Specific examples of such a crosslinking agent typically include, but are not particularly limited to, a phenol-based crosslinking agent, a melamine-based crosslinking agent, a urea-based crosslinking agent, or a thiourea-based crosslinking agent, which has, in the molecule, a crosslinking group such as an alkoxymethyl group (e.g., a hydroxymethyl group, a methoxymethyl group, a butoxymethyl group). These may be low-molecular-weight compounds or high-molecular-weight compounds.

The crosslinking agent contained in the release agent composition usually has two or more crosslinking groups. However, from the viewpoint of reproducibly realizing more suitable curing, the number of crosslinking groups contained in the compound, namely a crosslinking agent, is preferably from 2 to 10 and more preferably from 2 to 6.

The crosslinking agent contained in the release agent composition preferably has an aromatic ring (e.g., a benzene ring, a naphthalene ring) in the molecule from the viewpoint of achieving higher heat resistance. Typical examples of such a crosslinking agent include, but are not limited to, a phenolic crosslinking agent.

The phenolic crosslinking agent having a crosslinking group is a compound having a crosslinking group bonded to an aromatic ring and having at least one of a phenolic hydroxyl group and an alkoxy group derived from a phenolic hydroxyl group. Examples of the alkoxy group derived from a phenolic hydroxyl group include, but are not limited to, a methoxy group or a butoxy group.

The aromatic ring bonded to the crosslinking group and the aromatic group bonded to the phenolic hydroxyl group and/or the alkoxy group derived from a phenolic hydroxyl group are both not limited to a non-condensed aromatic ring such as a benzene ring, and may each be a condensed ring such as a naphthalene ring or anthracene.

When a plurality of aromatic rings are present in the molecule of the phenolic crosslinking agent, the crosslinking group and the phenolic hydroxyl group or the alkoxy group derived from a phenolic hydroxyl group may be bonded to the same aromatic ring in the molecule or may be bonded to different aromatic rings.

The aromatic ring bonded to the crosslinking group and/or the phenolic hydroxyl group or the alkoxy group derived from a phenolic hydroxyl group may be further substituted with an alkyl group (e.g., a methyl group, an ethyl group, a butyl group), a hydrocarbon group (e.g., an aryl group such as a phenyl group), and/or a halogen atom (e.g., a fluorine atom).

For instance, specific examples of the phenolic crosslinking agent having a crosslinking group include a compound represented by any of formulas (L1) to (L4). 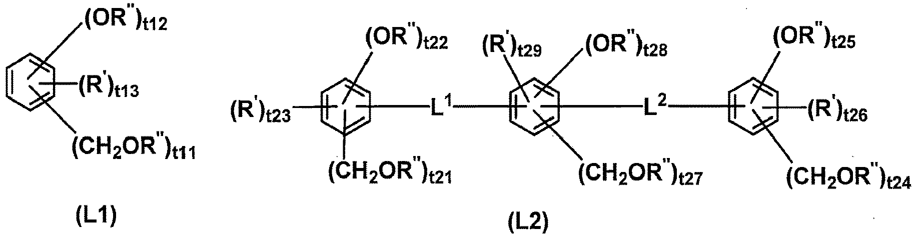 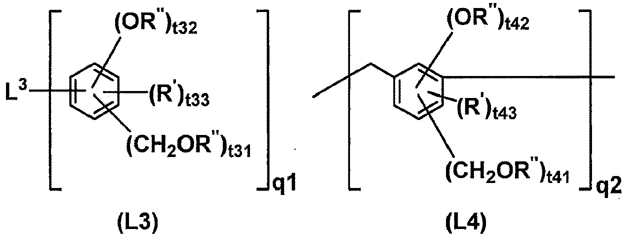 wherein respective R's each independently represents a fluorine atom, an aryl group, or an alkyl group, respective R"s each independently represents a hydrogen atom or an alkyl group, L¹ and L² each independently represent a single bond, a methylene group, or a propane-2, 2-diyl group, L³ is determined according to q1 and represents a single bond, a methylene group, a propane-2,2-diyl group, a methantriyl group, or an ethane-1, 1,1-triyl group, t11, t12, and t13 are integers satisfying 2 ≤ t11 ≤ 5, 1 ≤ t12 ≤ 4, 0 ≤ t13 ≤ 3, respectively, and t11+t12+t13 ≤ 6, and t21, t22, and t23 are integers satisfying 2 ≤ t21 ≤ 4, 1 ≤ t22 ≤ 3, 0 ≤ t23 ≤ 2, respectively, and t21+t22+t23 ≤ 5, t24, t25, and t26 are integers satisfying 2 ≤ t24 ≤ 4, 1 ≤ t25 ≤ 3, 0 ≤ t26 ≤ 2, respectively, and t24+t25+t26 ≤ 5, t27, t28, and t29 are integers satisfying 0 ≤ t27 ≤ 4, 0 ≤ t28 ≤ 4, 0 ≤ t29 ≤ 4, respectively, and t27+t28+t29 ≤ 4, t31, t32, and t33 are integers satisfying 2 ≤ t31 ≤ 4, 1 ≤ t32 ≤ 3, 0 ≤ t33 ≤ 2, respectively, and t31+t32+t33 ≤ 5, t41, t42, and t43 are integers satisfying 2 ≤ t41 ≤ 3, 1 ≤ t42 ≤ 2, 0 ≤ t43 ≤ 1, respectively, and t41+t42+t43 ≤ 4, q1 is 2 or 3, q2 represents the number of repetitions and is an integer of 0 or more, and specific examples of the aryl group or the alkyl group include the same as the following specific examples, but a phenyl group is preferable as the aryl group, and a methyl group or a t-butyl group is preferable as the alkyl group.

Specific examples of the compounds represented by the formulas (L1) to (L4) are given below, but the compounds are not limited thereto. Note that these compounds may be synthesized by a known procedure, and can also be obtained, for example, as a product of ASAHI YUKIZAI CORPORATION, or Honshu Chemical Industry Co., Ltd.

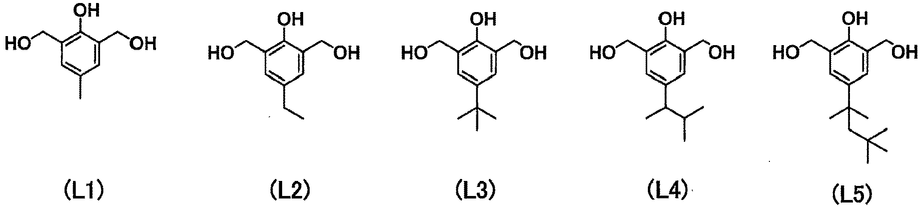

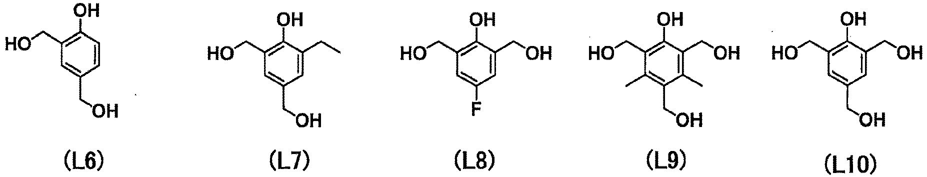

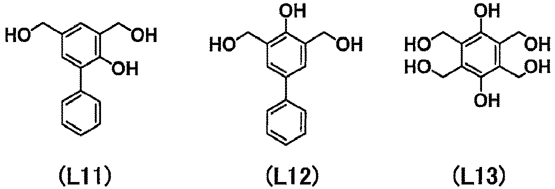

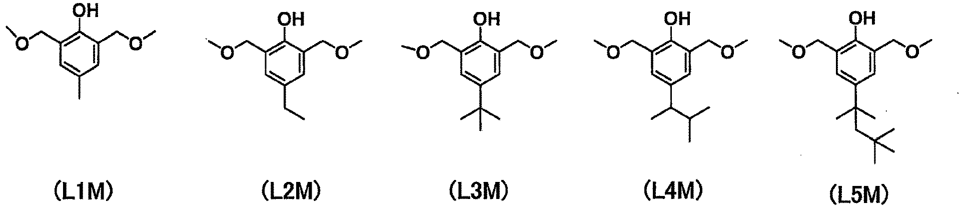

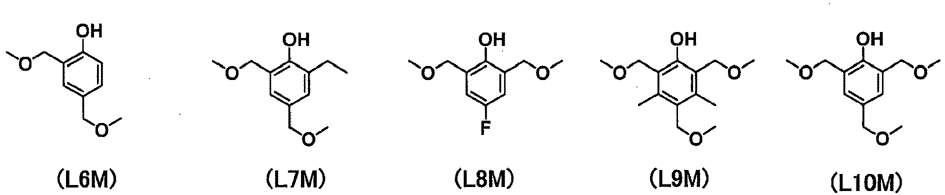

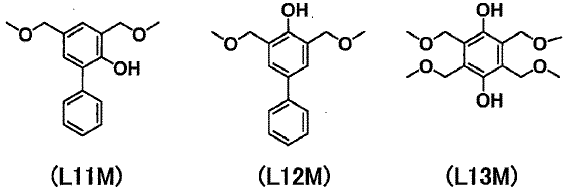

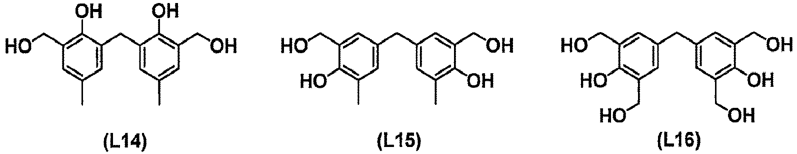

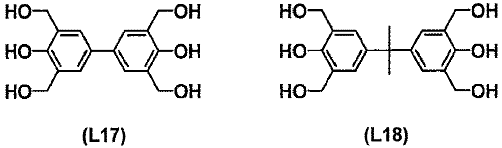

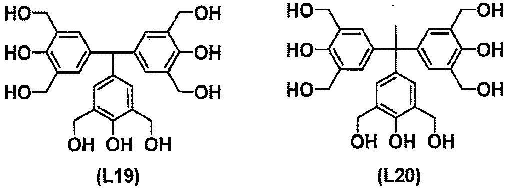

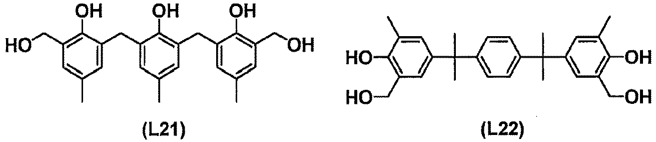

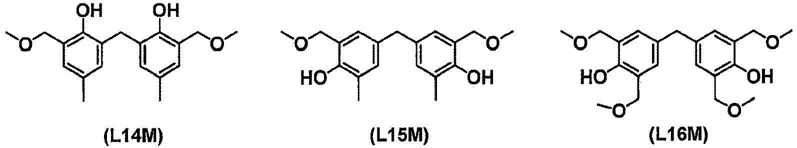

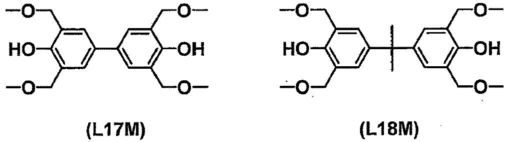

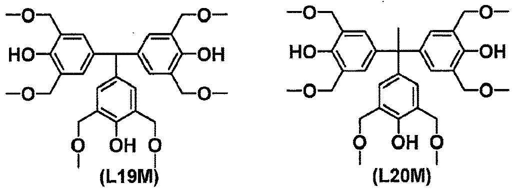

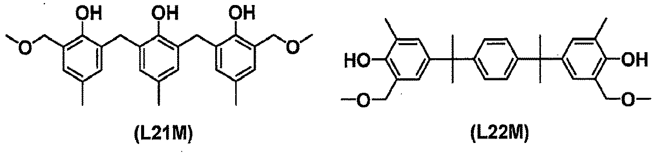

The melamine-based crosslinking agent having a crosslinking group is a melamine derivative, a 2,4-diamino-1, 3,5-triazine derivative, or a 2-amino-1,3,5-triazine derivative in which at least one of hydrogen atoms of an amino group bonded to the triazine ring is substituted with the crosslinking group. The triazine ring may further have a substituent such as an aryl group (e.g., a phenyl group).

Specific examples of the melamine-based crosslinking agent having a crosslinking group include, but are not limited to, mono, bis, tris, tetrakis, pentakis, or hexakis alkoxymethylmelamine (e.g., N,N,N',N',N",N"-hexakis(methoxymethyl)melamine, N,N,N',N',N",N"-hexakis(butoxymethyl)melamine) or mono, bis, tris, or tetrakis alkoxymethylbenzoguanamine (e.g., N,N,N',N'-tetrakis(methoxymethyl)benzoguanamine, N,N,N',N'-tetrakis(butoxymethyl)benzoguanamine).

The urea-based crosslinking agent having a crosslinking group is a derivative of a urea bond-containing compound, and has a structure in which at least one of hydrogen atoms of an NH group constituting a urea bond is substituted with a crosslinking group.

Specific examples of the urea-based crosslinking agent having a crosslinking group include, but are not limited to, mono, bis, tris, or tetrakis alkoxymethyl glycoluril (e.g., 1,3,4,6-tetrakis(methoxymethyl)glycoluril, 1,3,4,6-tetrakis(butoxymethyl)glycoluril) or mono, bis, tris, or tetrakis(alkoxymethyl)urea (e.g., 1,3-bis(methoxymethyl)urea, 1,1,3,3-tetrakis(methoxymethyl)urea).

The thiourea-based crosslinking agent having a crosslinking group is a derivative of a thiourea bond-containing compound, and has a structure in which at least one of hydrogen atoms of an NH group constituting a thiourea bond is substituted with a crosslinking group.

Specific examples of the thiourea-based crosslinking agent having a crosslinking group include, but are not limited to, mono, bis, tris, or tetrakis alkoxymethylthiourea (e.g., 1,3-bis(methoxymethyl)thiourea, 1,1,3,3-tetrakis methoxymethylthiourea).

The amount of crosslinking agent contained in the release agent composition varies depending on, for instance, the coating method to be employed and the desired film thickness, and thus cannot be generally defined, but is usually from 0.001 to 80 mass% based on the film constituent components. From the viewpoint of achieving suitable curing and reproducibly obtaining a laminate in which the first substrate and the second substrate can be satisfactorily separated, the amount is preferably 0.01 mass% or larger, more preferably 0.05 mass% or larger, still more preferably 0.5 mass% or larger, and still more preferably 1.0 mass% or larger, and is preferably 50 mass% or less, more preferably 40 mass% or less, still more preferably 20 mass% or less, and still more preferably 10 mass% or less

### <<Acid generating agent and acid>>

To promote, for instance, the crosslinking reaction, the release agent composition may contain an acid generating agent or an acid.

Examples of the acid generating agent include a thermal acid generator or a photoacid generator.

The thermal acid generator is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, or TAG2700 (manufactured by King Industries, Inc.), or SI-45, SI-60, SI-80, SI-100, SI-110, and SI-150 (manufactured by Sanshin Chemical Industry Co., Ltd.), or other organic sulfonic acid alkyl esters.

Examples of the photoacid generator include an onium salt compound, a sulfonimide compound, or a disulfonyldiazomethane compound.

Specific examples of the onium salt compound include, but are not limited to, an iodonium salt compound (e.g., diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, bis(4-tert-butylphenyl)iodonium trifluoromethanesulfonate) or a sulfonium salt compound (e.g., triphenylsulfonium hexafluoroantimonate, triphenylsulfonium nonafluoronormal butane sulfonate, triphenylsulfonium camphor sulfonate, triphenylsulfonium trifluoromethanesulfonate).

Specific examples of the sulfonimide compound include, but are not limited to, N-(trifluoromethanesulfonyloxy)succinimide, N-(nonafluoronormalbutanesulfonyloxy)succinimide, N-(camphorsulfonyloxy)succinimide, or N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, or methylsulfonyl-p-toluenesulfonyl diazomethane.

Specific examples of the acid include, but are not limited to, an arylsulfonic acid or a pyridinium salt, or a salt thereof (e.g., p-toluenesulfonic acid, pyridinium p-toluenesulfonic acid (pyridinium p-toluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, 1-naphthalenesulfonic acid), an arylcarboxylic acid or a salt thereof (e.g., salicylic acid, benzoic acid, hydroxybenzoic acid, naphthalenecarboxylic acid), a chain or cyclic alkylsulfonic acid or a salt thereof (e.g., trifluoromethanesulfonic acid, camphorsulfonic acid), or a chain or cyclic alkyl carboxylic acid or a salt thereof (e.g., citric acid).

The amount of acid generating agent contained in the release agent composition varies depending on, for instance, the type of crosslinking agent together used and the heating temperature when a film is formed, and thus cannot be generally defined, but is usually from 0.01 to 5 mass% based on the film constituent components.

### <<<Surfactant>>>

The release agent composition may contain a surfactant for the purpose of, for example, adjusting the liquid physical properties of the composition itself or the film physical properties of the resulting film, or reproducibly preparing a highly uniform release agent composition.

Examples of the surfactant include: polyoxyethylene alkyl ethers (e.g., polyoxyethylene lauryl ether, polyoxyethylene stearyl ether, polyoxyethylene cetyl ether, polyoxyethylene oleyl ether); polyoxyethylene alkyl allyl ethers (e.g., polyoxyethylene octyl phenol ether, polyoxyethylene nonyl phenol ether); polyoxyethylene-polyoxypropylene block copolymers; sorbitan fatty acid esters (e.g., sorbitan monolaurate, sorbitan monopalmitate, sorbitan monostearate, sorbitan monooleate, sorbitan trioleate, sorbitan tristearate); nonionic surfactants (e.g., polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate)); fluorosurfactants (e.g., F-top EF301, EF303, and EF352 (trade name, manufactured by TOCHEM PRODUCTS CO., LTD.), MEGAFAC F171, F173, R-30, and R-30N (trade name, manufactured by DIC Corporation), Fluorad FC430 and FC431 (trade name, manufactured by Sumitomo 3M Limited), AsahiGuard AG710, Surflon S-382, SC101, SC102, SC103, SC104, SC105, and SC106 (trade name, manufactured by AGC, Inc.); or an organosiloxane polymer KP341 (manufactured by Shin-Etsu Chemical Co., Ltd.).

One kind of such a surfactant may be used singly, or two or more kinds thereof may be used in combination.

The amount of the surfactant is usually 2 mass% or less based on the film constituent components of the release agent composition.

### <<Solvent>>

The release agent composition preferably contains a solvent.

As such a solvent, it is possible to use, for example, a highly polar solvent capable of satisfactorily dissolving film constituent components such as an organic resin and a crosslinking agent, and it is also possible to use, as necessary, a less polar solvent for the purpose of adjusting, for instance, the viscosity and the surface tension. Note that in the present invention, the less polar solvent is defined as a solvent having a relative permittivity of less than 7 at a frequency of 100 kHz and the highly polar solvent is defined as a solvent having a relative permittivity of 7 or more at a frequency of 100 kHz. One kind of the solvent may be used singly, or two or more kinds thereof may be used in combination.

Here, examples of the highly polar solvent include: an amide-based solvent (e.g., N,N-dimethylformamide, N,N-dimethylacetamide, N,N-dimethylisobutyramide, N-methylpyrrolidone, 1,3-dimethyl-2-imidazolidinone); a ketone-based solvent (e.g., ethyl methyl ketone, isophorone, cyclohexanone); a cyano-based solvent (e.g., acetonitrile, 3-methoxypropionitrile); a polyhydric alcohol-based solvent (e.g., ethylene glycol, diethylene glycol, triethylene glycol, dipropylene glycol, 1,3-butanediol, 2,3-butanediol);
a monohydric alcohol-based solvent, other than aliphatic alcohols, (e.g., propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, tetrahydrofurfuryl alcohol); or a sulfoxide-based solvent (e.g., dimethyl sulfoxide).

Examples of the less polar solvent include: a chlorine-based solvent (e.g., chloroform, chlorobenzene); an aromatic hydrocarbon-based solvent (e.g., toluene, xylene, tetralin, cyclohexylbenzene, alkylbenzene such as decylbenzene); an aliphatic alcohol-based solvent (e.g., 1-octanol, 1-nonanol, 1-decanol); an ether-based solvent (e.g., tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, triethylene glycol butyl methyl ether); or an ester-based solvent (e.g., methyl benzoate, ethyl benzoate, butyl benzoate, isoamyl benzoate, bis(2-ethylhexyl) phthalate, dibutyl maleate, dibutyl oxalate, hexyl acetate, propylene glycol monomethyl ether acetate, diethylene glycol monoethyl ether acetate, diethylene glycol monobutyl ether acetate).

The content of the solvent is appropriately determined in consideration of, for instance, the viscosity of the desired composition, the coating method to be employed, and the thickness of the film to be produced. The content is 99 mass% or less based on the total composition, preferably from 70 to 99 mass% based on the total composition, that is, the amount of the film constituent components in that case is from 1 to 30 mass% based on the total composition.

The viscosity and surface tension of the release agent composition are appropriately adjusted by changing, for instance, the type of the solvent used, the ratio thereof, and the concentration of the film constituent components in consideration of various factors such as the coating method to be used and the desired film thickness.

In an embodiment of the present invention, the release agent composition contains a glycol-based solvent, for example, from the viewpoint of reproducibly obtaining a highly uniform composition, from the viewpoint of reproducibly obtaining a highly storage stable composition, and from the viewpoint of reproducibly obtaining a composition that provides a highly uniform film. Note that the "glycol-based solvent" as used herein is a generic term for glycols, glycol monoethers, glycol diethers, glycol monoesters, glycol diesters, and glycol ester ethers.

An example of the preferred glycol-based solvent is represented by formula (G): 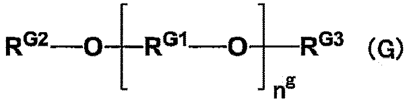 wherein R^{G1}s each independently represent a C₂₋₄ linear or branched alkylene group, R^{G2} and R^{G3} each independently represent a hydrogen atom, a linear or branched C₁₋₈ alkyl group, or an alkylacyl group in which the alkyl moiety is a linear or branched C₁₋₈ alkyl group, and n^{g} is an integer of 1 to 6.

Specific examples of the C₂₋₄ linear or branched alkylene group include, but are not limited to, an ethylene group, a trimethylene group, a 1-methylethylene group, a tetramethylene group, a 2-methylpropane-1, 3-diyl group, a pentamethylene group, or a hexamethylene group.

Among them, a C₂₋₃ linear or branched alkylene group is preferable and a C₃ linear or branched alkylene group is more preferable, for example, from the viewpoint of reproducibly obtaining a highly uniform composition, from the viewpoint of reproducibly obtaining a highly storage stable composition, and from the viewpoint of reproducibly obtaining a composition that provides a highly uniform film.

Specific examples of the linear or branched C₁₋₈ alkyl group include, but are not limited to, a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, or a 1-ethyl-2-methyl-n-propyl group.

Among them, a methyl group or an ethyl group is preferable and a methyl group is more preferable, for example, from the viewpoint of reproducibly obtaining a highly uniform composition, from the viewpoint of reproducibly obtaining a highly storage stable composition, and from the viewpoint of reproducibly obtaining a composition that provides a highly uniform film.

Specific examples of the C₁₋₈ linear or branched alkyl group in the alkylacyl group in which the alkyl moiety is a C₁₋₈ linear or branched alkyl group include the same as the specific examples described above.

Among them, a methylcarbonyl group or an ethylcarbonyl group is preferable and a methylcarbonyl group is more preferable, for example, from the viewpoint of reproducibly obtaining a highly uniform composition, from the viewpoint of reproducibly obtaining a highly storage stable composition, and from the viewpoint of reproducibly obtaining a composition that provides a highly uniform film.

The n^{g} is preferably 4 or less, more preferably 3 or less, still more preferably 2 or less, and most preferably 1, for example, from the viewpoint of reproducibly obtaining a highly uniform composition, from the viewpoint of reproducibly obtaining a highly storage stable composition, and from the viewpoint of reproducibly obtaining a composition that provides a highly uniform film.

For example, from the viewpoint of reproducibly obtaining a highly uniform composition, from the viewpoint of reproducibly obtaining a highly storage stable composition, and from the viewpoint of reproducibly obtaining a composition that provides a highly uniform film, at least one of R^{G2} and R^{G3} in formula (G) is preferably a linear or branched C₁₋₈ alkyl group. More preferably, one of R^{G2} and R^{G3} is a linear or branched C₁₋₈ alkyl group, and the other is a hydrogen atom or an alkylacyl group in which the alkyl moiety is a C₁₋₈ linear or branched alkyl group.

For example, from the viewpoint of reproducibly obtaining a highly uniform composition, from the viewpoint of reproducibly obtaining a highly storage stable composition, and from the viewpoint of reproducibly obtaining a composition that provides a highly uniform film, the content of the glycol-based solvent is preferably 50 mass% or larger, more preferably 70 mass% or larger, still more preferably 80 mass% or larger, still more preferably 90 mass% or larger, and still more preferably 95 mass% or larger based on the solvent contained in the release agent composition.

For example, from the viewpoint of reproducibly obtaining a highly uniform composition, from the viewpoint of reproducibly obtaining a highly storage stable composition, and from the viewpoint of reproducibly obtaining a composition that provides a highly uniform film, the film constituent components in the release agent composition are uniformly dispersed or dissolved in the solvent and preferably dissolved.

### <Inorganic material layer>

The laminate may have an inorganic material layer.

The inorganic material layer is usually interposed between the release layer and the adhesive layer. The inorganic material layer suppresses mixing of the release layer and the adhesive layer.

The inorganic material layer is not particularly limited as long as the layer is made of an inorganic material. Examples thereof include a layer formed of a compound such as an oxide, a nitride, or a carbide composed of at least one element selected from the group consisting of silicon, boron, titanium, zirconium, and aluminum, or a mixture thereof.

Preferably, the inorganic material layer is a layer obtained by plasma-polymerizing an organosilicon compound.

The inorganic material layer is formed by, for example, chemical vapor deposition (CVD). For example, plasma polymerization coating is performed by chemical vapor deposition.

Examples of the material used for the plasma polymerization coating include an organosilicon compound. For example, by performing plasma polymerization coating, using an organosilicon compound, on the release layer or the adhesive layer, the raw material gas containing the organosilicon compound can be decomposed to form an inorganic material layer, namely a thin film containing a Si-O bond on the release layer or the adhesive layer.

A gas containing oxygen such as O₂ or N₂O is preferably blended in the raw material gas containing the organosilicon compound. In addition, a rare gas such as argon or helium may be blended, as a carrier gas, in the raw material gas. In a preferred example of the process of decomposing the raw material gas, the raw material gas is decomposed by plasma generated under an appropriate pressure condition by using a plasma generator. Incidentally, a technique of decomposing a raw material gas by using plasma to form a film (layer) may be generally referred to as a plasma polymerization process.

Examples of the organosilicon compound include a siloxane compound, a disilazane compound, or a silane compound.

Examples of the siloxane compound include chain siloxane (e.g., 1,1,3,3-tetramethyldisiloxane, pentamethyldisiloxane, hexamethyldisiloxane, 1,1,3,3-tetraphenyl-1,3-dimethyldisiloxane, 1,3-divinyltetramethyldisiloxane, 1,1,3,3,5,5-hexamethyltrisiloxane, 1,1,1,3,5,5,5-heptamethyltrisiloxane, octamethyltrisiloxane, 1,1,1,3,5,7,7,7-octamethyltetrasiloxane, decamethyltetrasiloxane, 1,1,5,5-tetraphenyl-1,3,3,5-tetramethyltrisiloxane); or cyclic siloxane (e.g., hexamethylcyclotrisiloxane, 1,3,5,7-tetramethylcyclotetrasiloxane, octamethylcyclotetrasiloxane, decamethylcyclopentasiloxane, 1,3,5,7-tetravinyl-1,3,5,7-tetramethylcyclotetrasiloxane).

Examples of the disilazane compound include 1,1,3,3-tetramethyldisilazane, hexamethyldisilazane, heptamethyldisilazane, hexamethylcyclotrisilazane, or 1,1,3,3,5,5,7,7-octamethylcyclotetrasilazane.

Examples of the silane compound include methylsilane, dimethylsilane, trimethylsilane, tetramethylsilane, trimethoxysilane, triethylsilane, trichloromethylsilane, dichlorodimethylsilane, chlorotrimethylsilane, tetramethoxysilane, trimethoxymethylsilane, ethyltrimethoxysilane, dimethoxydimethylsilane, methoxytrimethylsilane, tetraethoxysilane, triethoxymethylsilane, triethoxyethylsilane, diethoxydimethylsilane, ethoxytrimethylsilane, diethoxymetylsilane, ethoxydimethylsilane, acetoxytrimethylsilane, allyloxytrimethylsilane, allyltrimethylsilane, butoxytrimethylsilane, butyltrimethoxysilane, diacetoxydimethylsilane, dimethoxydiphenylsilane, diethoxydiphenylsilane, dimethoxymethylphenylsilane, ethoxydimethylvinylsilane, diphenylsilanediol, triacetoxymethylsilane, triacetoxyethylsilane, 3-glycidyloxypropyltrimethoxysilane, hexyltrimethoxysilane, 3-mercaptopropyltrimethoxysilane, octadecyltriethoxysilane, triethoxyoctylsilane, triethoxyphenylsilane, trimethylphenylsilane, propoxytrimethylsilane, triethoxypropylsilane, tetraacetoxysilane, tetrabutoxysilane, tetrapropoxysilane, triacetoxyvinylsilane, triethoxyvinylsilane, trimethoxyvinylsilane, triphenylsilanol, trimethylvinylsilane, or tris(2-methoxyethoxy)vinylsilane.

The thickness of the inorganic material layer is not particularly limited, but is usually from 1 to 1,000 nm and preferably from 100 to 500 nm.

Hereinafter, an example of the laminate will be described with reference to the drawings.

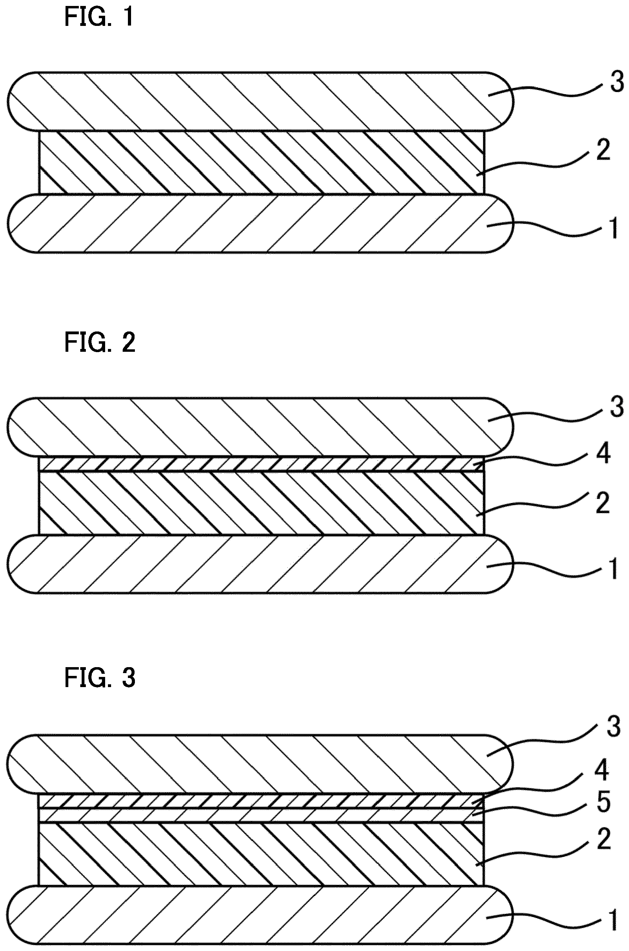

Fig. 1 is a schematic cross-sectional view of an example of a laminate.

The laminate of Fig. 1 includes, in sequence, a first substrate 1, an adhesive layer 2, and a second substrate 3.

The adhesive layer 2 is interposed between the first substrate 1 and the second substrate 3. The adhesive layer 2 is in contact with the first substrate 1 and the second substrate 3.

Fig. 2 is a schematic cross-sectional view of another example of the laminate.

The laminate of Fig. 2 includes, in sequence, a first substrate 1, an adhesive layer 2, a release layer 4, and a second substrate 3.

The adhesive layer 2 is interposed between the first substrate 1 and the second substrate 3. The adhesive layer 2 is in contact with the first substrate 1 and the release layer 4.

The release layer 4 is interposed between the first substrate 1 and the second substrate 3. The release layer 4 is in contact with the adhesive layer 2 and the second substrate 3.

The laminate in another example may include, in sequence, a first substrate 1, a release layer 4, an adhesive layer 2, and a second substrate 3.

Fig. 3 is a schematic cross-sectional view of another example of the laminate.

The laminate of Fig. 3 includes, in sequence, a first substrate 1, an adhesive layer 2, an inorganic material layer 5, a release layer 4, and a second substrate 3.

The adhesive layer 2 is interposed between the first substrate 1 and the second substrate 3. The adhesive layer 2 is in contact with the first substrate 1 and the inorganic material layer 5.

The release layer 4 is interposed between the first substrate 1 and the second substrate 3. The release layer 4 is in contact with the inorganic material layer 5 and the second substrate 3.

The inorganic material layer 5 is interposed between the first substrate 1 and the second substrate 3. The inorganic material layer 5 is in contact with the adhesive layer 2 and the release layer 4.

The laminate in another example may include, in sequence, a first substrate 1, a release layer 4, an inorganic material layer 5, an adhesive layer 2, and a second substrate 3.

Note that in the laminate in another example, another layer may be further provided at least between the substrate and the layer or between the layer and the layer in Figs. 1 to 3.

The laminate of the present invention is suitably produced, for example, by the following method for producing a laminate according to the present invention.

### (Method for producing laminate)

The method for producing a laminate according to the present invention includes, for example, an adhesive coating layer forming step and an attaching step, and further optionally includes other steps such as a release agent coating layer forming step, an inorganic material layer forming step, and/or an adhesive layer forming step.

### <Release agent coating layer forming step>

The release agent coating layer forming step is a step of applying a release agent composition to form a release agent coating layer that provides a release layer.

When the release agent composition used is free of a solvent, for example, a release agent coating layer is formed by applying the release agent composition onto the first substrate or the second substrate. However, heating may be performed in the process of forming the layer as necessary for the purpose of, for instance, softening the layer to improve adhesion to the substrate.

When the release agent composition used contains a solvent, for example, the release agent composition is applied onto the first substrate or the second substrate to form a solvent-containing coating layer, and the solvent is removed by heating the solvent-containing coating layer, whereby the release agent coating layer is formed. However, heating may not be performed in the process of forming the layer unless necessary due to circumstances such as removal of the solvent during film formation by spinning.

The coating method is not particularly limited, but is usually a spin coating method.

The heating temperature is appropriately determined according to the boiling point of the solvent and the purpose of heating, but is usually from 50 to 250°C. The heating time is appropriately determined according to the heating temperature, but is usually from 30 seconds to 1 hour.

The heating can be performed using, for example, an oven or a hot plate.

### <Inorganic material layer forming step>

The inorganic material layer forming step is not particularly limited as long as it is a step of forming an inorganic material layer, and examples thereof include a step including the method for forming an inorganic material layer as described above in the description of the inorganic material layer.

### <Adhesive coating layer forming step>

The adhesive coating layer forming step is not particularly limited as long as it is a step of applying an adhesive composition of the present invention to form an adhesive coating layer that provides an adhesive layer. This is exemplified by a step including a method of applying the adhesive composition onto the first substrate, the release layer, the inorganic material layer, or the second substrate, and then heating (preheating treatment) the adhesive composition to form an adhesive coating layer, namely an uncured or incompletely cured adhesive layer. In this way, an adhesive coating layer is formed, for example, on the first substrate, the release layer, the inorganic material layer, or the second substrate.

The coating method is not particularly limited, but is usually a spin coating method. Incidentally, it is possible to adopt a method of separately forming a coating film by, for instance, a spin coating method and attaching a sheet-like coating film as an adhesive coating layer.

The thickness of the adhesive coating layer is appropriately determined in consideration of, for instance, the thickness of the adhesive layer in the laminate.

When the adhesive composition contains a solvent, the applied adhesive composition is usually heated (preheating treatment).

The heating temperature of the applied adhesive composition varies depending on, for instance, the type and amount of the adhesive component contained in the adhesive composition, whether or not a solvent is contained, the boiling point of the solvent used, and the desired thickness of the adhesive layer, and thus cannot be generally specified, but it is usually from 80 to 150°C. The heating time is usually from 30 seconds to 5 minutes.

The heating can be performed using, for instance, a hot plate or an oven.

### <Adhesive layer forming step>

The adhesive layer forming step is not particularly limited as long as it is a step of heating the adhesive coating layer to form the adhesive layer (post-heating treatment).

For example, the first substrate on which the adhesive coating layer is formed and the second substrate on which the release layer is formed are used, and the two substrates (the first substrate and the second substrate) are disposed so as to sandwich the two layers (the adhesive coating layer and the release layer), so that the adhesive coating layer and the release layer are brought into contact with each other, and then the heat treatment may be performed. In addition, for example, the second substrate and the first substrate on which the release layer and the adhesive coating layer are formed are used, and the two substrates (the first substrate and the second substrate) are disposed so as to sandwich the two layers (the release layer and the adhesive coating layer), so that the second substrate and the adhesive coating layer may be brought into contact with each other, and then the heat treatment may be performed. Alternatively, for example, the first substrate on which the release layer is formed and the second substrate on which the adhesive coating layer is formed are used, and the two substrates (the first substrate and the second substrate) are disposed so as to sandwich the two layers (the release layer and the adhesive coating layer), so that the release layer and the adhesive coating layer may be brought into contact with each other, and then the heat treatment may be performed.

For example, the second substrate and the first substrate on which the release layer, the inorganic material layer, and the adhesive coating layer are formed are used, and the two substrates (the first substrate and the second substrate) are disposed so as to sandwich the three layers (the release layer, the inorganic material layer, and the adhesive coating layer), so that the second substrate and the adhesive coating layer may be brought into contact with each other, and then the heat treatment may be performed. Alternatively, for example, the first substrate on which the release layer and the inorganic material layer are formed and the second substrate on which the adhesive coating layer is formed are used, and the two substrates (the first substrate and the second substrate) are disposed so as to sandwich the three layers (the release layer, the inorganic material layer, and the adhesive coating layer), so that the inorganic material layer and the adhesive coating layer may be brought into contact with each other, and then the heat treatment may be performed.

The temperature and time of heating are not particularly limited as long as they are the temperature and time at which the adhesive coating layer is converted into the adhesive layer.

The heating temperature is preferably 120°C or higher, for example, from the viewpoint of achieving a sufficient curing rate, and is preferably 260°C or lower, for example, from the viewpoint of preventing modification of each layer (including the second substrate and the first substrate) constituting the laminate. Usually, the heating temperature in the adhesive layer forming step is higher than the heating temperature in the attaching step.

The heating time is preferably 1 minute or longer and more preferably 5 minutes or longer from the viewpoint of realizing suitable attachment of the respective layers (including the second substrate and the first substrate) constituting the laminate. From the viewpoint of suppressing or avoiding, for instance, an adverse effect on each layer due to excessive heating, the heating time is preferably 180 minutes or less and more preferably 120 minutes or less.

The heating can be performed using, for instance, a hot plate or an oven.

The heating may be performed stepwise.

### <Attaching step>

Usually, the attaching step is performed between the adhesive coating layer forming step and the adhesive layer forming step in order to sufficiently attach the first substrate and the second substrate.

The attaching step is a step of attaching the first substrate and the second substrate under heating and increased pressure so that the first substrate and the second substrate are in contact with each other with the adhesive coating layer interposed therebetween.

When the method for producing a laminate includes the release layer forming step, the attaching step is a step of attaching the first substrate and the second substrate under heating and increased pressure so that the first substrate and the second substrate are in contact with each other with the release agent coating layer and the adhesive coating layer interposed therebetween.

The attaching step is not particularly limited as long as the substrate and the layer can be attached and the substrate and the layer are not damaged. The attaching step is typically a step of heating and applying a load in the thickness direction of the first substrate and the second substrate, and more preferably, a step of heating and applying, under reduced pressure, a load in the thickness direction of the first substrate and the second substrate.

The heating temperature is not particularly limited as long as it is room temperature (25°C) or higher, but is usually 50°C or higher, and from the viewpoint of avoiding excessive heating, the heating temperature is usually 220°C or lower, and in some embodiments, 170°C or lower.

The load is not particularly limited as long as the substrate and the layer can be attached and the substrate and the layer are not damaged, but is, for example, from 0.5 to 50 kN.

In addition, the pressure at the time of attaching is, for example, from 0.1 to 20 N/mm². Note that the pressure refers to a force (load) per unit area (mm²) of the substrate in contact with the jig for applying a load.

The degree of pressure reduction is not particularly limited as long as the substrate and the layer can be attached and the substrate and the layer are not damaged, but is, for example, from 10 to 10,000 Pa.

### (Method for producing processed substrate)

The method for producing a processed substrate according to the present invention includes, for example, at least a processing step (first step) and a detachment step (second step), and further optionally includes other steps such as a removal step.

### <Processing step (first step)>

The processing step is not particularly limited as long as it is a step of processing the first substrate in the laminate of the present invention, and includes, for example, a polishing treatment and/or a through-electrode forming treatment.

### <<Polishing treatment>>

The polishing treatment is not particularly limited as long as it is a treatment of polishing a surface that is of the first substrate, which is a substrate including a semiconductor, and is opposite to a surface on the second substrate side to thin the semiconductor. Examples thereof include physical polishing using a polishing agent or a grindstone.

The polishing treatment can be performed using a general polishing apparatus used for polishing a semiconductor (e.g., a silicon wafer).

By the polishing treatment, the thickness of the semiconductor is reduced to produce a semiconductor thinned to a desired thickness. The thickness of the thinned semiconductor is not particularly limited, but may be, for example, from 30 to 300 um or from 30 to 100 µm.

### <<Through-electrode forming step>>

The polished semiconductor may have a through-electrode for realizing conduction between thinned semiconductors when a plurality of thinned semiconductors are layered.

Therefore, the method for producing a processed substrate may include a through-electrode forming process of forming a through-electrode in the polished semiconductor after the polishing process and before the detachment step.

The method of forming a through-electrode in a semiconductor is not particularly limited, and examples thereof include forming a through hole and filling the formed through hole with a conductive material.

The through hole is formed by, for example, photolithography.

The through-hole is filled with the conductive material by, for example, a plating technique.

### <Detachment step (second step)>

The detachment step is not particularly limited as long as it is a step of, after the processing step, separating the processed first substrate from the second substrate.

Examples thereof include, but are not limited to, solvent detachment, detachment by light irradiation (laser light, non-laser light), mechanical detachment by equipment having a sharp part (so-called a die bonder), and manual detachment between the first substrate and the second substrate. Usually, the detachment is performed after the laminate of the present invention is produced and subjected to predetermined processing and so on.

In particular, when the laminate includes a release layer and the release layer is a release layer formed using an organic resin that absorbs light and causes modification necessary for improving the detachment performance, the release layer can be detached by, for example, laser irradiation from the second substrate side.

The laser light has a wavelength of from 190 nm to 400 nm or from 190 nm to 600 nm (e.g., 308 nm, 355 nm, 532 nm), so that UV light may be used.

The detachment can be performed by setting the processing energy density of the pulse laser to about 50 to 500 mJ/cm².

When the laminate includes a release layer, detachment usually occurs inside the release layer or at an interface between the release layer and an adjacent substrate or layer (e.g., an adhesive layer). The fact that detachment occurs inside the release layer means that the release layer is cleaved.

### <Removal step>

The removing step is not particularly limited as long as it is a step of removing the layer on the semiconductor substrate and the residue thereof after the detachment step, and examples thereof include dissolution and removal. In addition, the removal may be performed using, for instance, a removal tape.

In the case of using a cleaning agent composition, for example, the first substrate may be immersed in the cleaning agent composition or the cleaning agent composition may be sprayed.

When a removal target is an adhesive layer or a residue thereof, particularly a polysiloxane-based adhesive or a residue thereof, a suitable example of the cleaning agent composition used in the present invention includes a cleaning agent composition containing a quaternary ammonium salt and a solvent.

The quaternary ammonium salt is composed of a quaternary ammonium cation and an anion, and is not particularly limited as long as it is used for this type of application.

Typical examples of such a quaternary ammonium cation include a tetra(hydrocarbon)ammonium cation. On the other hand, examples of an anion paired therewith include, but are not limited to, a hydroxide ion (OH⁻); a halogen ion (e.g., a fluorine ion (F⁻), a chlorine ion (Cl⁻), a bromine ion (Br⁻), an iodine ion (I⁻)); a tetrafluoroborate ion (BF₄⁻); or a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred embodiment, the fluorine-containing quaternary ammonium salt is tetra(hydrocarbon) ammonium fluoride.

Specific examples of the hydrocarbon group in tetra (hydrocarbon) ammonium fluoride include a C₁₋₂₀ alkyl group, a C₂₋₂₀ alkenyl group, a C₂₋₂₀ alkynyl group, or a C₆₋₂₀ aryl group.

In a more preferred embodiment, the tetra(hydrocarbon) ammonium fluoride includes tetraalkylammonium fluoride.

Specific examples of tetraalkylammonium fluoride include, but are not limited to, tetramethylammonium fluoride, tetraethylammonium fluoride, tetrapropylammonium fluoride, or tetrabutylammonium fluoride. Among them, tetrabutylammonium fluoride is preferable.

As the quaternary ammonium salt such as tetra (hydrocarbon)ammonium fluoride, a hydrate may be used. In addition, one kind of the quaternary ammonium salts such as tetra (hydrocarbon)ammonium fluoride may be used singly or two or more kinds thereof may be used in combination.

The amount of the quaternary ammonium salt is not particularly limited as long as it is dissolved in the solvent contained in the cleaning agent composition, but is usually from 0.1 to 30 mass% based on the cleaning agent composition.

The solvent contained in the cleaning agent composition is not particularly limited as long as it is used for this type of use and dissolves a salt such as the quaternary ammonium salt. However, from the viewpoint of reproducibly obtaining a cleaning agent composition having excellent cleaning performance and the viewpoint of obtaining a cleaning agent composition having excellent uniformity by dissolving a salt such as a quaternary ammonium salt well, for example, the cleaning agent composition preferably contains one or two or more kinds of amide-based solvent.

Suitable examples of the amide-based solvent include an acid amide derivative represented by formula (Z).

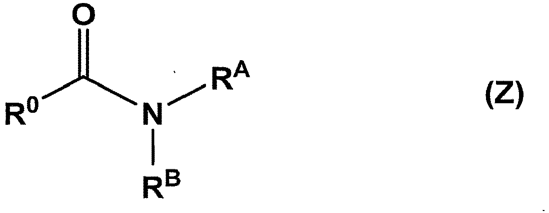

wherein R⁰ represents an ethyl group, a propyl group or an isopropyl group, and an ethyl group is preferable. R^{A} and R^{B} each independently represent a C₁₋₄ alkyl group. The C₁₋₄ alkyl group may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, or a cyclobutyl group. Among them, R^{A} and R^{B} are each preferably a methyl group or an ethyl group.

Examples of the acid amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide is particularly preferable.

The acid amide derivative represented by formula (Z) may be synthesized by a substitution reaction between a corresponding carboxylic acid ester and an amine, or a commercially available product may be used.

Another example of the preferred amide-based solvent is a lactam compound represented by formula (Y). 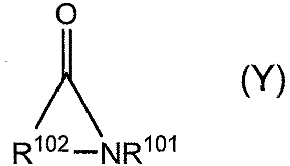 wherein R¹⁰¹ represents a hydrogen atom or a C₁₋₆ alkyl group, and R¹⁰² represents a C₁₋₆ alkylene group.

Specific examples of the C₁₋₆ alkyl group include, but are not limited to, a methyl group, an ethyl group, an n-propyl group, or an n-butyl group, and specific examples of the C₁₋₆ alkylene group include, but are not limited to, a methylene group, an ethylene group, a trimethylene group, tetramethylene, a pentamethylene group, or a hexamethylene group.

Specific examples of the lactam compound represented by formula (Y) include an α-lactam compound, a β-lactam compound, a γ-lactam compound, or a δ-lactam compound, and one kind of these compounds may be used singly, or two or more kinds thereof may be used in combination.

In a preferred embodiment, the lactam compound represented by formula (Y) contains 1-alkyl-2-pyrrolidone(N-alkyl-γ-butyrolactam), in a more preferred embodiment, N-methylpyrrolidone (NMP) or N-ethylpyrrolidone (NEP), and in a still more preferred embodiment, N-methylpyrrolidone (NMP).

The cleaning agent composition may contain one or two or more other organic solvents different from the above-mentioned amide compound.

Such other organic solvents are used for this type of application, and are not particularly limited as long as they are organic solvents compatible with the above-described amide compound.

Examples of the preferred other solvent include, but are not limited to, an alkylene glycol dialkyl ether, an aromatic hydrocarbon compound, or a cyclic structure-containing ether compound.

The amount of the other organic solvent different from the amide compound described above is usually appropriately determined to be 95 mass% or less in the solvent contained in the cleaning agent composition as long as the quaternary ammonium salt contained in the cleaning agent composition is not precipitated or separated, and is uniformly mixed with the amide compound described above.

Note that the cleaning agent composition may contain water as the solvent, but usually, only an organic solvent is intended to be used as the solvent, for example, from the viewpoint of avoiding, for instance, corrosion of the substrate. Note that in this case, it is not to be denied that hydration water of the salt or water contained in a trace amount in the organic solvent is contained in the cleaning agent composition. The water content of the cleaning agent composition used in the present invention is usually 5 mass% or less.

### Examples

Hereinafter, the present invention will be described more specifically with reference to examples, but the present invention is not limited to the following examples. Note that the apparatuses used are as follows.

### [Apparatuses]

(1) Stirrer A: Rotation and revolution mixer ARE-500 manufactured by THINKY CORPORATION
(2) Stirrer B: AS ONE Corporation mixing rotor VMR-5R
(3) Spin coating device: coater manufactured by SUSS MicroTec SE
(4) Vacuum heating attachment apparatus: VE09-07 manufactured by Ayumi Industry Co., Ltd.

### (To synthesize polymer contained in release layer)

### [Synthesis Example 1]

First, 86.36 g of 1,4-dioxane and 86.36 g of toluene were added to 56.02 g of 1-phenylnaphthylamine, 50.00 g of 1-pyrenecarboxaldehyde (manufactured by Maruzen Pharmaceuticals Co., Ltd.), 6.67 g of 4-(trifluoromethyl)benzaldehyde, and 2.46 g of methanesulfonic acid, and the mixture was stirred under reflux for 18 hours under a nitrogen atmosphere. After completion of the reaction, the mixture was diluted with 96 g of tetrahydrofuran, and the diluted solution was added dropwise to methanol to give a precipitate. The resulting precipitate was filtered, washed with methanol, and dried at 60°C under reduced pressure to prepare 72.12 g of a novolac resin. The weight average molecular weight measured in terms of standard polystyrene by GPC was 1100.

### [Synthesis Example 2]

Under nitrogen, 8.00 g of carbazole (manufactured by Tokyo Chemical Industry Co., Ltd.), 7.55 g of 1-naphthaldehyde (manufactured by Tokyo Chemical Industry Co., Ltd.), and 0.95 g of p-toluenesulfonic acid monohydrate (manufactured by KANTO CHEMICAL CO., INC.) were added to a 100-mL four-necked flask, and 8 g of 1,4-dioxane (manufactured by KANTO CHEMICAL CO., INC.) was further added thereto. The mixture was stirred, and heated to 100°C for dissolution to initiate polymerization. After 4 hours, the mixture was allowed to cool to 60°C, and then diluted by adding 40 g of chloroform (manufactured by KANTO CHEMICAL CO., INC.), and reprecipitated in 200 g of methanol. The resulting precipitate was filtered, and dried in a vacuum dryer at 60°C for 10 hours, and further at 120°C for 24 hours to prepare a desired polymer (hereinafter, abbreviated as PCzNA).

The weight average molecular weight Mw of PCzNA measured in terms of polystyrene by GPC was 2600. The obtained polymer was dissolved in PGMEA (propylene glycol monomethyl ether acetate), and ion exchange was performed using a cation exchange resin and an anion exchange resin for 4 hours to prepare a target polymer solution.

PCzNA has the following repeating units:

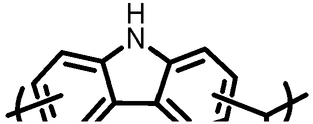

### [Synthesis Example 3]

A 500-ml separable flask was purged with nitrogen; N-methyl-2-pyrrolidone (NMP) as a solvent was charged into the separable flask in an amount such that the solid content after polymerization would be 15 mass%; 15.69 g (49.0 mmol) of 2,2'-bis(trifluoromethyl)benzidine (TFMB) as a diamine was further charged therein; and the mixture was stirred to dissolve TFMB. Then, 9.82 g (45.0 mmol) of pyromellitic dianhydride (PMDA) as tetracarboxylic dianhydride and 2.22 g (5.0 mmol) of 4,4' (hexafluoroisopropylidene)diphthalic anhydride (6FDA) were added. Next, the mixture was stirred at 80°C for 4 hours under a nitrogen flow to perform polymerization, thereby obtaining an NMP solution containing polyamic acid. The weight average molecular weight (Mw) of the obtained polyamic acid was 180,000.

### [1] To prepare composition

### [Preparation Example 1]

First, 4.0 g of a compound represented by formula (L) (trade name: TMOM-BP, manufactured by Honshu Chemical Industry Co., Ltd.) as a crosslinking agent, 0.60 g of pyridinium p-toluenesulfonate as an acid catalyst, and 0.06 g of R-30N (trade name, manufactured by DIC CORPORATION) as a surfactant were mixed with 20 g of the novolac resin obtained in Synthesis Example 1, and the mixture was dissolved in 100.8 g of propylene glycol monomethyl ether and 100.8 g of propylene glycol monomethyl ether acetate to prepare a solution. Thereafter, filtration was performed using a polyethylene microfilter having a pore size of 0.2 um to prepare a solution containing a release agent composition.

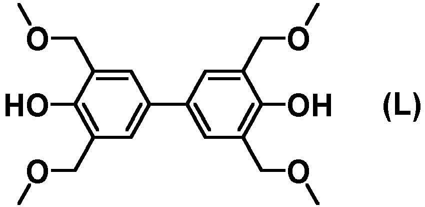

### [Preparation Example 2]

In a 50-mL screw vial, 6.74 g of the polymer solution obtained in Synthesis Example 2 (30 mass% PGMEA solution of PCzNA), 11.26 g of 20 mass% solution obtained by dissolving polymethyl methacrylic acid (Tg: 48°C, weight average molecular weight: 54000, manufactured by FUJIFILM Wako Pure Chemical Corporation) in PGMEA, and 7.01 g of PGMEA as a solvent were added, and the mixture was stirred with a stirrer A for 5 minutes to obtain a release agent composition.

### [Preparation Example 3]

In a 50 mL screw vial, 10 g of the polymer solution obtained in Synthesis Example 3 was placed, and NMP was then added to adjust the solution viscosity to 51,000 mPa·s, thereby obtaining a release agent composition.

### [Example 1-1]

To a 200-mL glass container with a lid were added 96.2 g of a p-menthane solution (concentration 81.7 mass%) of a vinyl group-containing MQ resin (manufactured by Wacker Chemie AG), 1.44 g of 1,1,3,3-tetramethyldisiloxane (manufactured by Tokyo Chemical Industry Co., Ltd.), and 12.9 g of SiH group-containing linear polydimethylsiloxane (manufactured by Wacker Chemie AG) having a viscosity of 1020 mPa·s, and the mixture was stirred with a stirrer A until the mixture became uniform. Thereafter, 0.005 g of a platinum catalyst (manufactured by Wacker Chemie AG) was added, and the mixture was stirred again with the stirrer A until the mixture became uniform, and then reacted at 40°C for 20 hours using a stirrer B to prepare a mixture (I).

Next, 0.50 g of 1,1-diphenyl-2-propyn-1-ol (manufactured by Tokyo Chemical Industry Co., Ltd.) and 0.50 g of 1-ethynyl-1-cyclohexanol (manufactured by Wacker Chemie AG) were added, and the mixture was stirred with the stirrer A for 5 minutes to prepare a mixture (II).

Then, 0.50 g of the mixture (II) was added to the mixture (I), and the mixture was stirred with the stirrer A until the mixture became uniform. Thereafter, 6.52 g of SiH group-containing linear polydimethylsiloxane (manufactured by Wacker Chemie, AG) having a viscosity of 100 mPa·s was added, and the mixture was stirred again with the stirrer A until the mixture became uniform. Thus, a mixture (III) was obtained.

Finally, the obtained mixture (III) was filtered through a 400-mesh nylon filter to prepare an adhesive composition. The obtained adhesive composition contains a reaction product (X) and a crosslinking agent (Y).

Incidentally, the vinyl group-containing MQ resin used itself is solid.

In addition, the 1,1,3,3-tetramethyldisiloxane and SiH group-containing linear polydimethylsiloxane having a viscosity of 1020 mPa·s used are liquid and chain compounds having a SiH group at the chain terminal.

The used SiH group-containing linear polydimethylsiloxane having a viscosity of 100 mPa·s is a crosslinking agent having a SiH group in a side chain.

### [Example 1-2]

To a 200-mL glass container with a lid were added 96.2 g of a p-menthane solution (concentration 81.7 mass%) of a vinyl group-containing MQ resin (manufactured by Wacker Chemie AG), 4.62 g of 1,1,3,3,5,5,7,7,9,9,11,11-dodecamethylhexasiloxane (manufactured by Tokyo Chemical Industry Co., Ltd.), and 12.9 g of SiH group-containing linear polydimethylsiloxane (manufactured by Wacker Chemie AG) having a viscosity of 1020 mPa·s, and the mixture was stirred with a stirrer A until the mixture became uniform. Thereafter, 0.01 g of a platinum catalyst (manufactured by Wacker Chemie AG) was added, and the mixture was stirred again with the stirrer A until the mixture became uniform, and then reacted at room temperature for 20 hours using a stirrer B to prepare a mixture (I).

Next, 1.00 g of 1,1-diphenyl-2-propyn-1-ol (manufactured by Tokyo Chemical Industry Co., Ltd.) and 1.00 g of 1-ethynyl-1-cyclohexanol (manufactured by Wacker Chemie AG) were added, and the mixture was stirred with the stirrer A for 5 minutes to prepare a mixture (II).

Then, 0.50 g of the mixture (II) was added to the mixture (I), and the mixture was stirred with the stirrer A until the mixture became uniform. Thereafter, 14.1 g of SiH group-containing linear polydimethylsiloxane (manufactured by Wacker Chemie, AG) having a viscosity of 100 mPa·s was added, and the mixture was stirred again with the stirrer A until the mixture became uniform. Thus, a mixture (III) was obtained.

Finally, the obtained mixture (III) was filtered through a 400-mesh nylon filter to prepare an adhesive composition. The obtained adhesive composition contains a reaction product (X) and a crosslinking agent (Y).

Incidentally, the vinyl group-containing MQ resin used itself is solid.

In addition, the 1,1,3,3,5,5,7,7,9,9,11,11-dodecamethylhexasiloxane and SiH group-containing linear polydimethylsiloxane having a viscosity of 1020 mPa·s used are liquid and chain compounds having a SiH group at the chain terminal.

The used SiH group-containing linear polydimethylsiloxane having a viscosity of 100 mPa·s is a crosslinking agent having a SiH group in a side chain.

### [Comparative Example 1-1]

To a 1000-mL container with a lid were added 385.2 g of a liquid mixture obtained by mixing a vinyl group-containing MQ resin (manufactured by Wacker Chemie AG) (A), a vinyl group-containing linear polydimethylsiloxane (manufactured by Wacker Chemie AG) having a viscosity of 200 mPa·s (B), and a SiH group-containing linear polydimethylsiloxane (manufactured by Wacker Chemie AG) having a viscosity of 100 mPa·s (C) at a mass ratio [A : B : C] of 51.6 : 9.5 : 38.9, and 57.87 g of a SiH group-containing linear polydimethylsiloxane (manufactured by Wacker Chemie AG) having a viscosity of 100 mPa·s was added thereto to prepare a mixture (I).

To a 50-mL glass container with a lid were added 3.05 g of 1,1-diphenyl-2-propyn-1-ol (manufactured by Tokyo Chemical Industry Co., Ltd.) and 3.05 g of 1-ethynyl-1-cyclohexanol (manufactured by Wacker Chemie AG), and the mixture was stirred with a stirrer A for 5 minutes to prepare a mixture (II).

Then, 4.07 g of the mixture (II) was added to the mixture (I), and the mixture was stirred overnight with a stirrer B to prepare a mixture (III).

To a 200-mL glass container with a lid were added 0.86 g of platinum catalyst (manufactured by Wacker Chemie AG) and 478.89 g of vinyl group-containing MQ resin (manufactured by Wacker Chemie AG), and the mixture was stirred overnight with the stirrer B to prepare a mixture (IV) .

Thereafter, 456.90 g of the mixture (IV) was added to the mixture (III), and the mixture was stirred with the stirrer B until the mixture became uniform. Thus, a mixture (V) was obtained.

Finally, the obtained mixture (V) was filtered through a 400-mesh nylon filter to prepare an adhesive composition. The obtained adhesive composition is free of a reaction product (X).

### [Comparative Example 1-2]

To a 100-mL glass container with a lid were added 0.12 g of 1,1-diphenyl-2-propyn-1-ol (manufactured by Tokyo Chemical Industry Co., Ltd.) and 0.12 g of 1-ethynyl-1-cyclohexanol (manufactured by Wacker Chemie AG), and the mixture was stirred with a stirrer A for 5 minutes. Next, 42.78 g of a p-menthane solution (concentration: 81.4 mass%) of a vinyl group-containing MQ resin (manufactured by Wacker Chemie AG) and 5.8 g of SiH group-containing linear polydimethylsiloxane (manufactured by Wacker Chemie AG) having a viscosity of 100 mPa·s were added, and the mixture was stirred with the stirrer A until the mixture became uniform to prepare a mixture (I).

To a 100-mL glass container with a lid were added 0.01 g of a platinum catalyst (manufactured by Wacker Chemie AG) and 45.77 g of a vinyl group-containing linear polydimethylsiloxane (manufactured by Wacker Chemie AG) having a viscosity of 200 mPa·s, and the mixture was stirred with the stirrer A until the mixture became uniform to prepare a mixture (II).

Thereafter, 9.16 g of the mixture (II) was added to the mixture (I), and the mixture was stirred with the stirrer A until the mixture became uniform. Thus, a mixture (III) was obtained.

Finally, the obtained mixture (III) was filtered through a 400-mesh nylon filter to prepare an adhesive composition. The obtained adhesive composition is free of a reaction product (X).

### [2] To produce substrate with release agent coating layer

### [Production Example 1]

The release agent composition obtained in Preparation Example 1 was spin-coated on a 300-mm glass wafer (manufactured by Corning Incorporated, thickness: 700 um) as a carrier-side substrate so that the film thickness in the finally obtained laminate was 200 nm, and heated at 300°C for 30 minutes to form a release agent coating layer on the glass wafer as a support substrate.

### [Production Example 2]

The release agent composition obtained in Preparation Example 2 was spin-coated on a 300-mm glass wafer (manufactured by Corning Incorporated, thickness: 700 um) as a carrier-side substrate so that the film thickness in the finally obtained laminate was 1500 nm, and heated at 200°C for 5 minutes to form a release agent coating layer on the glass wafer as a support substrate.

### [Production Example 3]

The release agent composition obtained in Preparation Example 3 was spin-coated on a 300-mm glass wafer (manufactured by Corning Incorporated, thickness: 700 um) as a carrier-side substrate so that the film thickness in the finally obtained laminate was 100 nm, and heated at 350°C for 60 minutes to form a release agent coating layer on the glass wafer as a support substrate.

### [3] To produce laminate and evaluate adhesiveness

### [Example 2-1]

The adhesive composition obtained in Example 1-1 was spin-coated on a 300-mm silicon wafer (thickness: 770 um) as a device-side wafer, and heated at 90°C for 3 minutes (preheating treatment) to form an adhesive coating layer on the wafer surface so that the thickness of the adhesive layer in the finally obtained laminate was about 60 um.

Thereafter, in a vacuum heating attachment apparatus, this silicon wafer having an adhesive coating layer and the glass wafer with a release agent coating layer obtained in Production Example 1 were attached so as to sandwich the adhesive coating layer and the release agent coating layer, and heated (post-heating treatment) on a hot plate at 200°C for 10 minutes with the device-side wafer facing down to prepare a laminate. Note that the attachment was performed at a temperature of 120°C or 130°C and a degree of vacuum of 700 Pa under a load of 15 kN for 180 seconds.

### [Example 2-2]

A laminate was obtained in the same manner as in Example 2-1, except that the adhesive composition obtained in Example 1-2 was used in place of the adhesive composition obtained in Example 1-1.

### [Example 2-3]

A laminate was obtained in the same manner as in Example 2-1 except that the glass wafer with a release agent coating layer as obtained in Production Example 2 was used instead of the glass wafer with a release agent coating layer as obtained in Production Example 1.

### [Example 2-4]

A laminate was obtained in the same manner as in Example 2-2 except that the glass wafer with a release agent coating layer as obtained in Production Example 2 was used instead of the glass wafer with a release agent coating layer as obtained in Production Example 1.

### [Example 2-5]

A laminate was obtained in the same manner as in Example 2-1 except that the glass wafer with a release agent coating layer as obtained in Production Example 3 was used instead of the glass wafer with a release agent coating layer as obtained in Production Example 1.

### [Example 2-6]

A laminate was obtained in the same manner as in Example 2-2 except that the glass wafer with a release agent coating layer as obtained in Production Example 3 was used instead of the glass wafer with a release agent coating layer as obtained in Production Example 1.

### [Comparative Example 2-1]

A laminate was obtained in the same manner as in Example 2-1, except that the adhesive composition obtained in Comparative Example 1-1 was used in place of the adhesive composition obtained in Example 1-1.

### [Comparative Example 2-2]

A laminate was obtained in the same manner as in Example 2-1, except that the adhesive composition obtained in Comparative Example 1-2 was used in place of the adhesive composition obtained in Example 1-1.

The laminates obtained in Example 2-1 and Example 2-2, Comparative Example 2-1, and Comparative Example 2-2 were used to evaluate the adhesiveness of each adhesive layer.

The adhesiveness was evaluated by visually checking the presence or absence of voids from the glass wafer (support) side of the laminate. In addition, protrusion of the adhesive layer from the outer periphery of the wafer was similarly visually checked from the glass wafer (support) side. The case where no void or protrusion of the adhesive layer was evaluated as good, and the case where some protrusion of the adhesive layer from the outer periphery of the wafer or void was found was evaluated as poor. The results of evaluating the adhesiveness are shown in Table 1.

**[Table 1]**

| | Adhesive composition | Release agent coating layer | Adhesiveness | |
|---|---|---|---|---|
| | | | Attachment temperature 120°C | Attachment temperature 130°C |
| Example 2-1 | Example 1-1 | Production Example 1 | Good | Good |
| Example 2-2 | Example 1-2 | Production Example 1 | Good | Good |
| Example 2-3 | Example 1-1 | Production Example 2 | Good | Good |
| Example 2-4 | Example 1-2 | Production Example 2 | Good | Good |
| Example 2-5 | Example 1-1 | Production Example 3 | Good | Good |
| Example 2-6 | Example 1-2 | Production Example 3 | Good | Good |
| Comparative Example 2-1 | Comparative Example 1-1 | Production Example 1 | Poor (protrusion) | Poor (voids) |
| Comparative Example 2-2 | Comparative Example 1-2 | Production Example 1 | Poor (protrusion) | Poor (protrusion) |

In all of Examples 2-1 to 2-6, neither a protrusion from the wafer nor a void was observed, and the adhesiveness was thus good. By contrast, in Comparative Example 2-1, some protrusion occurred during attachment at 120°C, and voids occurred at 130°C. In Comparative Example 2-2, some protrusion was observed at both 120°C and 130°C, and the adhesiveness was poor.

Table 1 has demonstrated that Example 1-1 to Example 1-2, which are the adhesive compositions of the present invention, unlikely have protrusion and exhibit good adhesiveness as compared with the adhesive compositions of Comparative Example 1-1 and Comparative Example 1-2.

### Industrial Applicability

The present invention makes it possible for the adhesive composition of the present invention to form a uniform adhesive layer without any void when two substrates are attached while being heated, and to suppress protrusion of the adhesive coating layer from a space between the two substrates. Therefore, the adhesive composition of the present invention is useful for attaching the two substrates in an environment where contamination is desired to be avoided.

### Reference Signs List

- 1: First substrate
- 2: Adhesive layer
- 3: Second substrate
- 4: Release layer
- 5: Inorganic material layer

## Claims

1. An adhesive composition comprising:
a reaction product (X) of a solid polymer (x1) having a first functional group and a liquid chain compound (x2) having, at a chain terminal, a second functional group capable of reacting with the first functional group, the reaction product (X) having the first functional group or the second functional group; and
a liquid crosslinking agent (Y) having the first functional group or the second functional group, provided that when the reaction product (X) has the first functional group, the liquid crosslinking agent (Y) has the second functional group, and when the reaction product (X) has the second functional group, the liquid crosslinking agent (Y) has the first functional group.

2. The adhesive composition according to claim 1, wherein
the solid polymer (x1) is a solid polyorganosiloxane having the first functional group,
the liquid chain compound (x2) is a compound having the second functional group at a chain terminal and having a siloxane linkage, and
the liquid crosslinking agent (Y) is a liquid polyorganosiloxane having the first functional group or the second functional group.

3. The adhesive composition according to claim 1, wherein
the first functional group is a C₂₋₄₀ alkenyl group, and the second functional group is a Si-H group.

4. The adhesive composition according to claim 1, wherein
the solid polymer (x1) is a polyorganosiloxane having a C₂₋₄₀ alkenyl group bonded to a silicon atom,
the liquid chain compound (x2) is a compound (x21) having a Si-H group at a chain terminal and having a siloxane linkage, and
the liquid crosslinking agent (Y) is a liquid polyorganosiloxane having a Si-H group.

5. The adhesive composition according to claim 4, wherein the compound (x21) is represented by the following formula (x21-1): 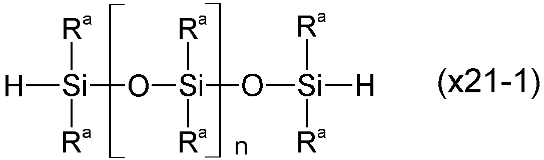 wherein R^{a}s each independently represent a substituted or unsubstituted C₁₋₁₀ hydrocarbon group without any aliphatic unsaturated bond, and n represents an integer of 0 or more.

6. The adhesive composition according to claim 1, wherein a constituent ratio between the solid polymer (x1) and the liquid chain compound (x2) in the reaction product (X) is from 95 : 5 to 10 : 90 as a mass ratio (polymer (x1) : compound (x2)).

7. The adhesive composition according to claim 1, wherein a mass ratio between the reaction product (X) and the liquid crosslinking agent (Y) (reaction product (X) :
liquid crosslinking agent (Y)) is from 99 : 1 to 60 : 40.

8. A laminate comprising a first substrate, a second substrate, and an adhesive layer provided between the first substrate and the second substrate, wherein
the adhesive layer is a layer formed from the adhesive composition according to any one of claims 1 to 7.

9. The laminate according to claim 8, further comprising a release layer provided between the first substrate and the second substrate.

10. The laminate according to claim 8, wherein the first substrate is a substrate comprising a semiconductor, and the second substrate is a support substrate.

11. A method for producing a laminate, comprising steps of:
applying the adhesive composition according to any one of claims 1 to 7 to form an adhesive coating layer that provides an adhesive layer; and
attaching a first substrate and a second substrate under heating and increased pressure so that the first substrate and the second substrate are in contact with each other with the adhesive coating layer interposed therebetween.

12. The method for producing a laminate according to claim 11, further comprising a step of, after the attaching step, heating the adhesive coating layer to form the adhesive layer.

13. The method for producing a laminate according to claim 11, further comprising a step of applying a release agent composition to form a release agent coating layer that provides a release layer, wherein
the attaching step is a step of attaching under heating and increased pressure so that the first substrate and the second substrate are in contact with each other with the release agent coating layer and the adhesive coating layer interposed therebetween.

14. The method for producing a laminate according to claim 11, wherein the first substrate is a substrate comprising a semiconductor, and the second substrate is a support substrate.

15. A method for producing a processed substrate, comprising:
a first step of processing the first substrate of the laminate according to claim 8; and
a second step of separating the first substrate processed in the first step from the second substrate.
